# EUROPÄISCHE PATENTSCHRIFT

(11) **EP 1 615 306 B1**
(45) Veröffentlichungstag und Bekanntmachung des Hinweises auf die Patenterteilung: **14.11.2007**
(21) Anmeldenummer: 05022400.5
(22) Anmeldetag: 16.05.2001
(51) Int. Cl.: H01S 5/183, H01S 5/04, H01S 5/026

(54) **Optisch gepumpte oberflächenemittierende Halbleiterlaservorrichtung und Verfahren zu deren Herstellung**
Optically pumped, surface-emitting semiconductor laser and method for producing the same
Dispositif laser à semi-conducteurs à émission surfacique pompé optiquement et procédé de fabrication

(30) Priorität: 30.05.2000 DE 10026734
(43) Veröffentlichungstag der Anmeldung: 11.01.2006
(62) Teilanmeldung aus: 01944933.9
(73) Patentinhaber: Osram Opto Semiconductors GmbH, 93049 Regensburg (DE)
(72) Erfinder: Linder, Norbert, 93173 Wenzenbach (DE); Albrecht, Tony, 93077 Bad Abbach (DE); Luft, Johann, 93195 Wolfsegg (DE)
(74) Vertreter: Epping - Hermann - Fischer

(56) Entgegenhaltungen:
- US-A- 5 796 771
- PATENT ABSTRACTS OF JAPAN Bd. 1996, Nr. 01, 31. Januar 1996 (1996-01-31) -& JP 07 249824 A (HITACHI LTD), 26. September 1995 (1995-09-26)
- GERHOLD M D ET AL: "NOVEL DESIGN OF A HYBRID-CAVITY SURFACE-EMITTING LASER" IEEE JOURNAL OF QUANTUM ELECTRONICS, IEEE INC. NEW YORK, US, Bd. 34, Nr. 3, 1. März 1998 (1998-03-01), Seiten 506-510, XP000742645 ISSN: 0018-9197
- ONISCHENKO A I ET AL: "Prediction of a large optical bistability in hybrid-cavity surface-emitting lasers" IEE PROCEEDINGS: OPTOELECTRONICS, INSTITUTION OF ELECTRICAL ENGINEERS, STEVENAGE, GB, Bd. 146, Nr. 1, 16. Februar 1999 (1999-02-16), Seiten 67-70, XP006013608 ISSN: 1350-2433

## Beschreibung

Die Erfindung bezieht sich auf eine optisch gepumpte oberflächenemittierende Halbleiterlaservorrichtung mit mindestens einer strahlungserzeugenden Quantentopfstruktur und mindestens einer Pumpstrahlungsquelle zum optischen Pumpen der Quantentopfstruktur, bei der die Pumpstrahlungsquelle eine kantenemittierende Halbleiterstruktur aufweist.

Sie bezieht sich weiterhin auf ein Verfahren zum Herstellen einer derartigen Halbleiterlaservorrichtung.

Eine Halbleiterlaservorrichtung der eingangs genannten Art ist aus der US 5,991,318 bekannt. Hierin ist ein optisch gepumpter Vertikalresonator-Halbleiterlaser mit einer monolithischen oberflächenemittierenden Halbleiterschichtstruktur beschrieben. Bei dieser bekannten Vorrichtung wird die optische Pumpstrahlung, deren Wellenlänge kleiner ist als die der erzeugten Laserstrahlung, von einer kantenemittierenden Halbleiterlaserdiode geliefert. Die kantenemittierende Halbleiterlaserdiode ist extern derart angeordnet, daß die Pumpstrahlung schräg von vorne in den Verstärkungsbereich der oberflächenemittierenden Halbleiterschichtstruktur eingestrahlt wird.

Ein besonderes Problem bei dieser bekannten Vorrichtung besteht darin, daß der Pumplaser exakt zur oberflächenemittierenden Halbleiterschichtstruktur positioniert sein muß und zusätzlich einer optischen Einrichtung zur Strahlfokussierung bedarf, um die Pumpstrahlung exakt in den gewünschten Bereich der oberflächenemittierenden Halbleiterschichtstruktur abzubilden. Diese Maßnahmen sind mit erheblichem technischen Aufwand verbunden.

Außerdem treten neben den Verlusten an den Optiken auch Koppelverluste auf, die den Gesamtwirkungsgrad des Systems reduzieren.

Ein weiteres Problem besteht darin, daß aufgrund des Pumpens von vorne nur wenige Quantentöpfe durch Pumpstrahlung angeregt werden können.

Dokument JP 07 249 824 A zeigt eine lateral gepumpte Laserstruktur mit einer oberflächenemittierenden Halbleiterlaservorrichtung.

Eine Aufgabe der vorliegenden Erfindung besteht darin, eine Halbleiterlaservorrichtung der eingangs genannten Art mit vereinfachter Justage von Pumpquelle und oberflächenemittierender Schichtstruktur und mit hoher Ausgangsleistung zur Verfügung zu stellen. Weiterhin soll ein technisch einfaches Verfahren zur Herstellung einer solchen Vorrichtung angegeben werden.

Diese Aufgabe wird durch eine optisch gepumpte oberflächenemittierende Halbleiterlaservorrichtung mit den Merkmalen des Patentanspruches 1 beziehungsweise ein Verfahren gemäß Patentanspruch 25 gelöst. Vorteilhafte Ausführungsformen und Weiterbildungen der Erfindung sind Gegenstand der abhängigen Ansprüche.

Gemäß der Erfindung ist bei einer optisch gepumpten oberflächenemittierenden Halbleiterlaservorrichtung der eingangs genannten Art die strahlungserzeugende Quantentopfstruktur und die kantenemittierende Halbleiterstruktur auf einem gemeinsamen Substrat epitaktisch und nacheinander aufgewachsen und übereinander angeordnet. Die Schichtdicken der einzelnen Halbleiterschichten lassen sich bei der Epitaxie sehr genau einstellen, so daß vorteilhafterweise eine hohe Positioniergenauigkeit der kantenemittierenden Halbleiterstruktur zur strahlungserzeugenden Quantentopfstruktur erreicht wird.

Weiterhin läßt sich mit der erfindungsgemäßen Vorrichtung ein homogenes optisches Pumpen der Quantentopfstruktur für hohe Ausgangsleistungen im Grundmodus erzielen.

Bei einer optisch gepumpten Halbleiterlaservorrichtung können die oberflächenemittierende Quantentopfstruktur und die Pumpstrahlungsquelle derart nebeneinander auf dem Substrat angeordnet sein, daß ein strahlungsemittierender Bereich der Pumpstrahlungsquelle und die Quantentopfstruktur auf gleicher Höhe über dem Substrat liegen. Dadurch wird erreicht, daß im Betrieb der Halbleiterlaservorrichtung Pumpstrahlung seitlich in die Quantentopfstruktur eingekoppelt wird. Das bedeutet, daß die Strahlachse der Pumpstrahlung im Wesentlichen parallel zur Substratoberfläche und damit im Wesentlichen vertikal zur Strahlachse des von der oberflächenemittierenden Halbleiterlaservorrichtung erzeugten Laserstrahls verläuft.

Im Betrieb wird bei einer derartigen Vorrichtung die Quantentopfstruktur von den Seitenflächen her zunächst transparent "gepumpt", bis schließlich deren gesamte laterale Querschnittsfläche laseraktiv ist. Durch das seitliche optische Pumpen wird zudem ein gleichmäßiges Füllen der Quantentöpfe mit Ladungsträgern erreicht.

Bevorzugt ist die Quantentopfstruktur von der kantenemittierenden Halbleiterstruktur umschlossen. In dieser ist mittels mindestens eines Strominjektionspfades auf der Oberfläche der Halbleiterlaserstruktur mindestens ein gewinngeführter strahlungsemittierender aktiver Bereich ausgebildet, der als Pumpstrahlungsquelle dient. Alternativ dient als Pumpstrahlungsquelle mindestens ein indexgeführter strahlungsemittierender aktiver Bereich der kantenemittierenden Halbleiterstruktur. Dieser ist beispielsweise mittels mindestens eines Strominjektionspfades auf der Oberfläche der kantenemittierenden Halbleiterstruktur in Verbindung mit entlang dem Strominjektionspfad ausgebildeten, beispielsweise geätzten Gräben in der Halbleiterstruktur definiert.

Vorzugsweise weisen die der strahlungserzeugenden Quantentopfstruktur zugewandten Enden der Strominjektionspfade zu dieser einen Abstand von 10µm - 50µm, besonders bevorzugt ca. 30 µm auf. Dadurch werden störende Leckströme und andere störende Einflüsse an den Grenzflächen zwischen der kantenemittierenden Halbleiterstruktur und der oberflächenemittierenden Schichtenfolge, d.h. den Einkoppelflächen für die Pumpstrahlung, reduziert.

Die oben angegebenen Ausführungsformen lassen sich vorteilhafterweise insgesamt mittels herkömmlicher Halbleiterprozesstechnik fertigen.

Fließt im Betrieb der Vorrichtung ein hinreichend hoher Strom durch die Injektionspfade in die aktive Schicht der Pumpstrahlungsquelle, kommt es zur Ausbildung verstärkter Spontanemission (Superstrahlung), die in den oberflächenemittierenden Laserbereich geführt und dort absorbiert wird. Die dadurch erzeugten Elektron-Loch-Paare werden in den Quantentöpfen gesammelt und führen zur Inversion im Verstärkungsbereich der oberflächenemittierenden Laserstruktur.

Die Anregung der oberflächenemittierenden Laserstruktur kann durch Pumpen der Quantentopfstruktur oder von an diese angrenzende Confinementschichten erfolgen. Im Falle des Pumpens der Confinementschichten wird die Pumpeffizienz vorzugsweise dadurch erhöht, daß deren Bandlücke zur Quantentopfstruktur hin abnimmt. Dies kann beispielsweise mittels Änderung der Materialzusammensetzung erreicht werden. Dadurch werden in den Confinementschichten interne elektrische Felder erzeugt, die die optisch generierten Ladungsträger in den aktiven Quantentopfbereich treiben.

Bei einer besonders bevorzugten Ausführungsform sind mehrere Pumpstrahlungsquellen sternförmig um die Quantentopfstruktur angeordnet, so daß in kurzer Zeit und sehr homogen die Quantentopfstruktur über ihren gesamten lateralen Querschnitt transparent "gepumpt" und laseraktiv wird.

Die Grenzfläche zwischen kantenemittierender Halbleiterstruktur und Quantentopfstruktur ist vorzugsweise zumindest teilweise reflektierend. Dadurch wird erreicht, daß sich an der Kante zum oberflächenemittierenden Laserbereich eine Rückreflexion in die kantenemittierende Halbleiterstruktur ergibt, was zur Ausbildung von Laserstrahlung in der Pumpquelle und damit zu erhöhter Pumpeffizienz führt.

Erzeugung von Laserstrahlung als Pumpstrahlung und damit er höhte Pumpeffizienz wird alternativ dadurch erreicht, daß jeweils zwei an gegenüberliegenden Seiten der Quantentopfstruktur angeordnete Pumpstrahlungsquellen zusammen eine Laserstruktur bilden. Die von der Quantentopfstruktur abgewandten, parallel zueinander liegenden Endflächen der kantenemittierenden Strahlungsquellen sind dazu als Spiegelflächen ausgebildet und dienen als Resonatorspiegel. Diese können beispielsweise durch Spalten und/oder Ätzen (z.B. Trockenätzen) erzeugt und mit einer Passivierungsschicht versehen und/oder hochreflektierend verspiegelt sein.

Die gegenüberliegenden Pumpstrahlungsquellen sind im Betrieb über die transparent gepumpte Quantentopfstruktur zu einem einzigen kohärent schwingenden Laser gekoppelt. Bei optimaler Endverspiegelung steht dann bis auf die Verluste an den Grenzflächen zwischen Pumplaser und oberflächenemittierendem Laser die gesamte im Pumplaser gespeicherte optische Leistung als Pumpleistung zur Verfügung.

Bevorzugt besitzt die kantenemittierende Halbleiterstruktur eine Large Optical Cavity(LOC)-Struktur. Bei dieser ist eine aktive Schicht zwischen einer ersten und einer zweiten Wellenleiterschicht eingebettet, die wiederum zwischen einer ersten und einer zweiten Mantelschicht eingebettet sind.

Bei einen vorteilhaften Weiterbildung der Erfindung ist vorgesehen, die kantenemittierende Halbleiterstruktur als Ringlaser zu bilden. Unter einem Ringlaser ist dabei eine Laserstruktur zu verstehen, bei der sich im Betrieb Ringmoden ausbilden können. Die Gestaltung des zugehörigen Laserresonators in Ringform ist dabei, wie im folgenden noch erläutert wird, vorteilhaft, jedoch nicht zwingend.

Der Resonator eines solchen Ringlasers kann mittels totalreflektierender Grenzflächen gebildet werden, so daß vorteilhafterweise keine hochreflektierenden Spiegel erforderlich sind. Damit wird auch die Gefahr einer geringeren Strahlungsausbeute aufgrund von Schäden an den Spiegeln reduziert. Weiterhin zeichnet sich ein Ringlaser durch ein vorteilhaft großes Modenvolumen und eine hohe Modenstabilität aus.

Bevorzugt ist die zu pumpende Quantentopfstruktur innerhalb des Ringresonators angeordnet, so daß das gesamte resonatorinterne Strahlungsfeld zum Pumpen der Quantentopfstruktur zur Verfügung steht. Ist die aktive Schicht der kantenemittierenden Halbleiterstruktur und die Quantentopfstruktur in derselben Höhe über dem Substrat angeordnet, so ergibt sich ein großer Überlapp zwischen dem zu pumpenden Volumen der Quantentopfstruktur und dem Strahlungsfeld der kantenemittierenden Halbleiterstruktur und damit eine hohe Pumpeffizienz.

Bei einer vorteilhaften Weiterbildung der Erfindung wird der Resonator des Ringlasers von einem ringförmig geschlossenen Wellenleiter gebildet. Die Führung des Pumpstrahlungsfeldes erfolgt darin durch Totalreflexion an den Begrenzungen des Wellenleiters, so daß auch hier vorteilhafterweise keine hochreflektierenden Spiegel benötigt werden. Weiterhin kann durch die Formgebung des ringförmig geschlossenen Wellenleiter das Pumpstrahlungsfeld sehr gut an das zu pumpende Volumen der Quantentopfstruktur angepaßt werden.

Die kantenemittierende Halbleiterstruktur ist bei einer bevorzugten Ausgestaltung der Erfindung von einem Medium umgeben, dessen Brechungsindex geringer ist als der Brechungsindex der Halbleiterstruktur. Dadurch entsteht an dem Übergang vom Halbleiter in das optisch dünnere, umgebende Medium eine totalreflektierende Fläche, die als Begrenzung des Laserresonators dient. Zur Bildung eines ringförmig geschlossenen Wellenleiters kann innerhalb der kantenemittierenden Halbleiterstruktur eine mit einem optisch dünneren Medium gefüllte Ausnehmung angeordnet sein.

Als umgebendes Medium eignet sich aufgrund des geringen Brechungsindex insbesondere Luft oder ein anderes gasförmiges Medium. Alternativ kann die kantenemittierende Halbleiterstruktur auch von einem anderen Material wie beispielsweise einem Halbleitermaterial, einem Halbleiteroxid oder einem Dielektrikum mit geringerem Brechungsindex umschlossen sein.

Bevorzugt ist die Halbleiterstruktur als zylindrischer Stapel kreisförmiger oder ringförmiger Halbleiterschichten gebildet. Der so geformte zylindrische Halbleiterkörper stellt zugleich den Ringlaserresonator dar, an dessen Mantelflächen das Strahlungsfeld totalreflektierend geführt wird.

Alternativ kann die Halbleiterstruktur auch prismatisch als Stapel von Halbleiterschichten in Form von Vielecken oder Vieleckringen gebildet sein. Durch diese Formgebung kann eine weitgehend homogene Strahlungsverteilung und entsprechend eine weitgehend homogene Pumpdichte in der Quantentopfstruktur erzielt werden.

Ein Stapel von Halbleiterschichten der beschriebenen Form kann vergleichsweise einfach, zum Beispiel durch Ätzen aus einer zuvor epitaktisch hergestellten Halbleiterschichtenfolge gebildet werden. Vorteilhafterweise wird so mit der Formung des Halbleiterkörpers zugleich auch der Laserresonator der kantenemittierenden Halbleiterstruktur gebildet, ohne daß zusätzliche Verspiegelungen erforderlich sind.

Bei einer besonders bevorzugten Weiterbildung der Halbleiterlaservorrichtung besitzt die Quantentopfstruktur mehr als 10 Quantentöpfe. Diese hohe Zahl von Quantentöpfen ist möglich, weil aufgrund der seitlichen Einkopplung der Pumpstrahlung alle Quantentöpfe unmittelbar gepumpt werden. Dadurch wird vorteilhafterweise eine hohe Verstärkung in der oberflächenemittierenden Quantentopfstruktur erzielt.

Die kantenemittierende Halbleiterstruktur ist bevorzugt derart ausgebildet, daß sie eine Pumpwelle erzeugt, deren Maximum auf Höhe der Quantentöpfe über dem Substrat liegt, besonders bevorzugt auf Höhe des Zentrums der Quantentopfstruktur.

Um besonders hohe Ausgangsleistungen zu erhalten, ist bei einer vorteilhaften Weiterbildung die kantenemittierende Halbleiterstruktur als sogenannter Mehrfach- oder Microstack-Laser mit mehreren laseraktiven Schichtfolgen (z.B. Doppelheterostrukturen) ausgebildet, die über Tunnelübergänge in Reihe geschaltet sind. Die Quantenwellstruktur weist dann vorteilhafterweise mehrere Quantenwellgruppen auf, die jeweils in Höhe einer laseraktiven Schichtenfolge der Pumpquelle liegen.

Zur Herstellung einer optisch gepumpten oberflächenemittierenden Halbleiterlaservorrichtung wird zunächst auf ein Substrat eine für einen oberflächenemittierenden Halbleiterlaser geeignete ersten Halbleiterschichtenfolge mit mindestens einer Quantentopfstruktur aufgebracht. Danach wird die erste Halbleiterschichtenfolge außerhalb des vorgesehenen Laserbereichs entfernt. Auf dem nach dem Entfernen der ersten Halbleiterschichtenfolge freigelegten Bereich über dem Substrat wird nachfolgend eine kantenemittierende zweite Halbleiterschichtenfolge abgeschieden, die geeignet ist, Pumpstrahlung zu erzeugen und in die Quantentopfstruktur zu senden. Nachfolgend wird in der kantenemittierenden Halbleiterschichtenfolge mindestens ein Strominjektionspfad ausgebildet.

Vorzugsweise wird zunächst eine Bufferschicht auf das Substrat aufgebracht. Auf dieser wird eine erste Confinementschicht abgeschieden. Auf die erste Confinementschicht wird nachfolgend eine für einen oberflächenemittierenden Halbleiterlaser geeignete Quantentopfstruktur aufgebracht, der eine zweite Confinementschicht folgt. Nach dem Entfernen der Confinementschichten und der Quantentopfstruktur und teilweise der Bufferschicht außerhalb des vorgesehenen oberflächenemittierenden Laserbereichs werden dann auf den freigelegten Bereich der Bufferschicht eine erste Mantelschicht, eine erste Wellenleiterschicht, eine aktive Schicht, eine zweite Wellenleiterschicht und eine zweite Mantelschicht nacheinander aufgebracht. Die jeweiligen Schichtdicken sind derart ausgelegt, daß die in der aktiven Schicht erzeugte Pumpstrahlung in die Quantentopfstruktur gelangt.

Bei einer Ausführungsform der Halbleiterlaservorrichtung gemäß der Erfindung sind die strahlungsemittierende Quantentopfstruktur und die Pumpstrahlungsquelle übereinander auf dem Substrat angeordnet. Die Quantentopfstruktur ist hierbei an die kantenemittierende Halbleiterstruktur optisch gekoppelt, so daß im Betrieb der Halbleiterlaservorrichtung Pumpstrahlung von der Pumpstrahlungsquelle in die Quantentopfstruktur geführt wird.

Die kantenemittierende Halbleiterstruktur weist bevorzugt eine erste Wellenleiterschicht und eine vom Substrat gesehen dieser nachgeordnete zweite Wellenleiterschicht auf, zwischen denen eine aktive Schicht angeordnet ist. Die Quantentopfstruktur ist auf der zweiten Wellenleiterschicht epitaktisch aufgewachsen, überdeckt nur einen Teilbereich der kantenemittierenden Halbleiterstruktur und ist an diese optisch angekoppelt.

Zur Verbesserung der Einkopplung der Pumpstrahlung in die Quantentopfstruktur ist die Grenzfläche zwischen zweiter Wellenleiterschicht und angrenzender Mantelschicht in der Nähe des oberflächenemittierenden Laserbereichs zur Quantentopfstruktur hin gebogen oder geknickt.

Um die Einkopplung von Pumpstrahlung in die oberflächenemittierende Halbleiterstruktur zu verbessern ist vorteilhafterweise der Brechungsindex der zweiten Wellenleiterschicht größer als der Brechungsindex der ersten Wellenleiterschicht und/oder ist die aktive Schicht asymmetrisch in dem von den beiden Wellenleiterschichten ausgebildeten Wellenleiter plaziert.

In der kantenemittierenden Halbleiterstruktur sind als Pumpstrahlungsquellen vorzugsweise analog zur oben beschriebenen ersten Ausführungsform einer oder mehrere gewinngeführte und/oder indexgeführte strahlungsemittierende aktive Bereiche ausgebildet.

Bei einem bevorzugten Verfahren zum Herstellen einer optisch gepumpten oberflächenemittierenden Halbleiterlaservorrichtung gemäß der oben angegebenen Ausführungsform und deren Weiterbildungen wird zunächst auf ein Substrat eine kantenemittierende Halbleiterschichtenfolge aufgebracht. Auf diese wird dann eine oberflächenemittierende Halbleiterlaserschichtenfolge mit mindestens einer Quantentopfstruktur aufgebracht. Danach wird die oberflächenemittierende Halbleiterlaserschichtenfolge außerhalb des vorgesehenen Laserbereichs entfernt, bevor mindestens ein Strominjektionspfad in der kantenemittierenden Halbleiterschichtenfolge ausgebildet wird.

Vorzugsweise wird hierzu zunächst eine Bufferschicht auf das Substrat aufgebracht. Nachfolgend wird auf dieser nacheinander eine erste Wellenleiterschicht, eine aktive Schicht und eine zweite Wellenleiterschicht abgeschieden. Auf die so hergestellte kantenemittierende Schichtenfolge wird dann eine erste Confinementschicht, eine oberflächenemittierende Halbleiterlaserschichtenfolge mit einer Quantentopfstruktur und eine zweite Confinementschicht aufgebracht. Die Confinementschichten, die oberflächenemittierende Halbleiterlaserschichtenfolge und teilweise die zweite Wellenleiterschicht werden dann außerhalb des vorgesehenen oberflächenemittierenden Laserbereichs entfernt.

Bei einem Verfahren zur Herstellung einer optisch gepumpten oberflächenemittierenden Halbleiterlaservorrichtung mit einem Ringlaser als Pumpstrahlungsquelle wird zunächst wie bereits beschrieben auf einem Substrat eine oberflächenemittierende Halbleiterschichtenfolge mit mindestens einer Quantentopfstruktur aufgebracht, die Schichtenfolge außerhalb des vorgesehenen Laserbereichs entfernt und die kantenemittierende Halbleiterstruktur der Pumpstrahlungsquelle auf den dadurch freigelegten Bereich aufgebracht.

Daraufhin wird der Außenbereich der kantenemittierenden Halbleiterstruktur zur Formung des Laserresonators entfernt. Bevorzugt wird dabei auch ein zentraler Teilbereich im Inneren der Halbleiterstruktur zur Bildung eines Ringresonators abgetragen. Die Entfernung dieser Teilbereiche kann beispielsweise mittels eines Trockenätzverfahrens erfolgen. Mit Vorteil ist keine aufwendige Nachbearbeitung der geätzten Flächen erforderlich.

Alternativ können die Verfahrensschritte auch in anderer Reihenfolge angewendet werden. Beispielsweise kann auf dem Substrat zunächst eine kantenemittierende Halbleiterstruktur aufgebracht werden, die dann im vorgesehenen Laserbereich der (noch zu bildenden) Quantentopfstruktur abgetragen wird. Auf den freigelegten Bereich wird im nächsten Schritt die oberflächenemittierende Halbleiterschichtenfolge mit mindestens einer Quantentopfstruktur aufgebracht. Abschließend wird wieder der Außenbereich der kantenemittierenden Halbleiterstruktur zur Formung des Laserresonators entfernt. In einer Variante des Verfahrens kann die Formung des Laserresonators auch vor der Aufbringung der oberflächenemittierenden Halbleiterschichtenfolge stattfinden.

Bei einer bevorzugten Weiterbildung der beiden oben angegebenen Ausführungsformen ist auf einer Seite der Quantentopfstruktur eine hochreflekierende Braggreflektor-Schichtenfolge ausgebildet, die einen Resonatorspiegel der oberflächenemittierenden Laserstruktur darstellt. Als zweiter, teildurchlässiger Resonatorspiegel ist auf der gegenüberliegenden Seite der Quantentopfstruktur eine weitere Braggreflektor-Schichtenfolge oder ein externen Spiegel angeordnet.

Bevorzugt besteht das Substrat aus einem Material, das für den in der Halbleiterlaservorrichtung erzeugten Laserstrahl durchlässig ist und ist der hochreflektierende Braggreflektor auf der vom Substrat abgewandten Seite der Quantentopfstruktur angeordnet. Dies ermöglicht eine kurze Verbindung zwischen den Halbleiterstrukturen und einer Wärmesenke und damit eine gute Wärmeableitung aus den Halbleiterstrukturen.

Um störende Quermoden (= Moden parallel zum Substrat - whispering modes) zu verhindern, sind im Randbereich und/oder in Ätzstrukturen der oberflächenemittierenden Halbleiterlaserschichtenfolge Absorberschichten angeordnet.

Die erfindungsgemäße Halbleiterlaservorrichtung eignet sich insbesondere zur Anwendung in einem externen Resonator, in dem sich ein frequenzselektives Element und/oder ein Frequenzverdoppler befindet.

Vorteilhafterweise kann die erfindungsgemäße Halbleiterlaservorrichtung über Modulation des Pumplasers durch Modulation des Pumpstromes oder über Kurzschlußschaltung der oberflächenemittierenden Halbleiterlaserschichtenfolge moduliert werden.

Weitere vorteilhafte Ausgestaltungen und Weiterbildungen der Vorrichtung und der Verfahren gemäß der Erfindung ergeben sich aus den im Folgenden in Verbindung mit den Figuren 1 bis 14 beschriebenen Ausführungsbeispielen.

Es zeigen:
Figur 1 eine schematische Darstellung eines Schnittes durch eine erste Halbleiterlaservorrichtung zur Erläuterung der Erfindung,
Figuren 2a bis 2e eine schematische Darstellung eines Verfahrensablaufes zur Herstellung der Halbleiterlaservorrichtung gemäß Figur 1,
Figur 3a eine schematische Darstellung eines Schnittes durch ein erstes Ausführungsbeispiel einer Halbleiterlaservorrichtung,
Figur 3b eine schematische Darstellung einer vorteilhaften Ausgestaltung des Wellenleiters des Ausführungsbeispieles gemäß Figur 3a,
Figuren 4a bis 4c eine schematische Darstellung eines Verfahrensablaufes zur Herstellung des Ausführungsbeispieles gemäß Figur 3a,
Figur 5 eine schematische Darstellung einer Draufsicht auf eine erste Anordnung von Strominjektionspfaden auf einer kantenemittierenden Halbleiterstruktur;
Figur 6 eine schematische Darstellung einer Draufsicht auf eine zweite Anordnung von Strominjektionspfaden auf einer kantenemittierenden Halbleiterstruktur,
Figur 7 eine schematische Darstellung einer Draufsicht auf eine dritte Anordnung von Strominjektionspfaden auf einer kantenemittierenden Halbleiterstruktur,
Figuren 8a und 8b schematische Darstellungen von Halbleiterlaservorrichtungen mit Absorberschichten,
Figuren 9a und 9b eine schematische Darstellung eines Schnittes und einer Draufsicht einer Halbleiterlaservorrichtung mit einem Ringlaser als Pumpstrahlungsquelle,
Figur 10 eine schematische Darstellung einer Draufsicht einer weiteren Halbleiterlaservorrichtung mit einem Ringlaser als Pumpstrahlungsquelle,
Figur 11a und 11b eine schematische Darstellung einer Draufsicht zweier weiterer Halbleiterlaservorrichtungen mit jeweils zwei Ringlasern als Pumpstrahlungsquelle,
Figur 12a und 12b eine schematische Darstellung eines Verfahrensablaufes zur Herstellung des Ausführungsbeispieles gemäß Figur 9a und 9b,
Figur 13 eine schematische Darstellung einer Halbleiterlaservorrichtung mit einem externen Resonator, und
Figur 14 eine schematische Darstellung einer modulierbaren Halbleiterlaservorrichtung.

Gleiche oder gleich wirkende Elemente sind in den Figuren mit denselben Bezugszeichen versehen.

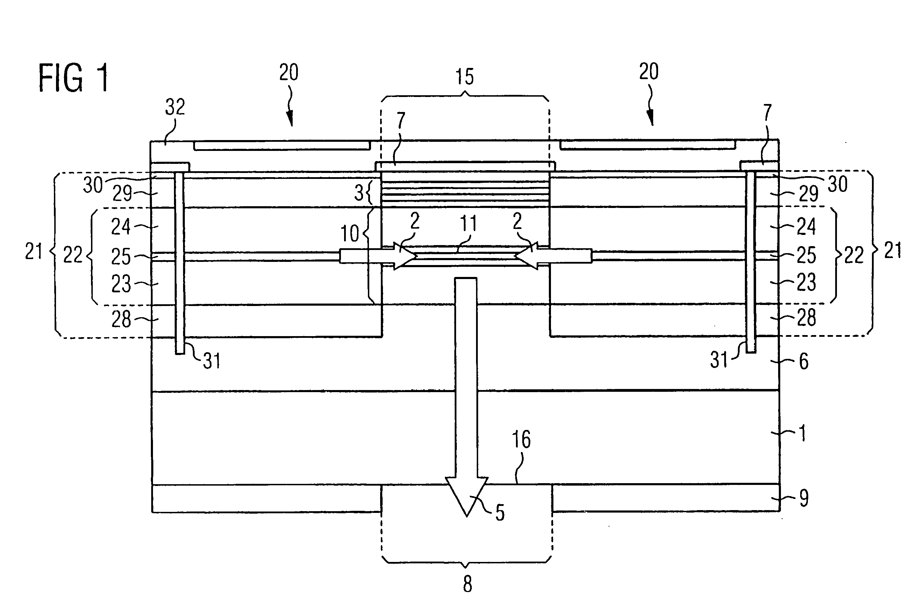

Die in Figur 1 dargestellte Vorrichtung ist beispielsweise ein optisch gepumpter oberflächenemittierender Halbleiterlaserchip mit einer Laseremission bei 1030nm. Bei diesem ist auf einem Substrat 1 eine Bufferschicht 6 aufgebracht. Das Substrat 6 besteht beispielsweise aus GaAs und die Bufferschicht 6 aus undotiertem GaAs.

Auf der Bufferschicht 6 ist mittig über dem Substrat eine oberflächenemittierende Halbleiterlaserstruktur 10 mit einer Quantentopfstruktur 11 aufgebracht, die den oberflächenemittierenden Laserbereich 15 darstellt. Die Halbleiterlaserstruktur 10 setzt sich zusammen, aus einer unmittelbar auf der Bufferschicht 6 befindlichen ersten Confinementschicht 12, einer auf dieser angeordneten Quantentopfstruktur 11 und einer auf der Quantentopfstruktur 11 aufgebrachten zweiten Confinementschicht 13.

Die Confinementschichten 12,13 bestehen beispielsweise aus undotiertem GaAs und die Quantentopfstruktur 11 weist zum Beispiel eine Mehrzahl (≥ 3) von Quantenwells auf, die aus undotiertem InGaAs bestehen, deren Dicke auf die Emission bei 1030nm eingestellt ist und zwischen denen sich Barriereschichten aus GaAs befinden.

Über der oberflächenemittierenden Halbleiterlaserstruktur ist ein Braggspiegel 3 mit beispielsweise 28 bis 30 Perioden GaAlAs(10%Al)/ GaAlAs(90%Al) abgeschieden, der einen hochreflektiven Resonatorspiegel darstellt.

In der Umgebung des Laserbereichs 15 ist auf der Bufferschicht 6 eine kantenemittierende Halbleiterlaserstruktur 21, beispielsweise eine bekannte Large Optical Cavity(LOC)-Single Quantum Well(SQW)-Laserstruktur für eine Emission bei ca. 1µm abgeschieden. Diese setzt sich beispielsweise zusammen, aus einer ersten Mantelschicht 28 (z.B. n-GaAl_{0.65}As), einer ersten Wellenleiterschicht 23 (z.B. n-GaAl_{0.1}As), einer aktiven Schicht 25 (z.B. eine undotierte InGaAs-SQW), einer zweiten Wellenleiterschicht 24 (z.B. p-GaAl_{0.1}As) und einer zweiten Mantelschicht 29 (z.B. p-GaAl_{0.65}As).

Auf der zweiten Mantelschicht 29 kann als Deckschicht 30 beispielsweise eine p⁺-dotierte ist GaAs-Schicht aufgebracht sein.

Der LOC-Bereich 22 ist höhengleich mit dem Quantentopfbereich der oberflächenemittierenden Laserstruktur 10 angeordnet, vorzugsweise befindet sich die aktive Schicht 25 in gleicher Höhe über dem Substrat 1 wie die Quantentopfstruktur 11.

Bei einer besonderen Ausführungsform dieser Halbleitervorrichtung weist die kantenemittierende Halbleiterstruktur 21 mehrere aktive Schichten 25 auf, die mittels Tunnelübergänge in Reihe geschaltet sind. Die Quantentopfstruktur 11 weist analog dazu mehrere Quantentopfgruppen aufweist, die jeweils in Höhe einer aktive Schicht 25 der kantenemittierenden Halbleiterstruktur 21 liegen.

Sämtliche Halbleiterschichten sind beispielsweise mittels metallorganischer Dampfphasenepitaxie (MOVPE) hergestellt.

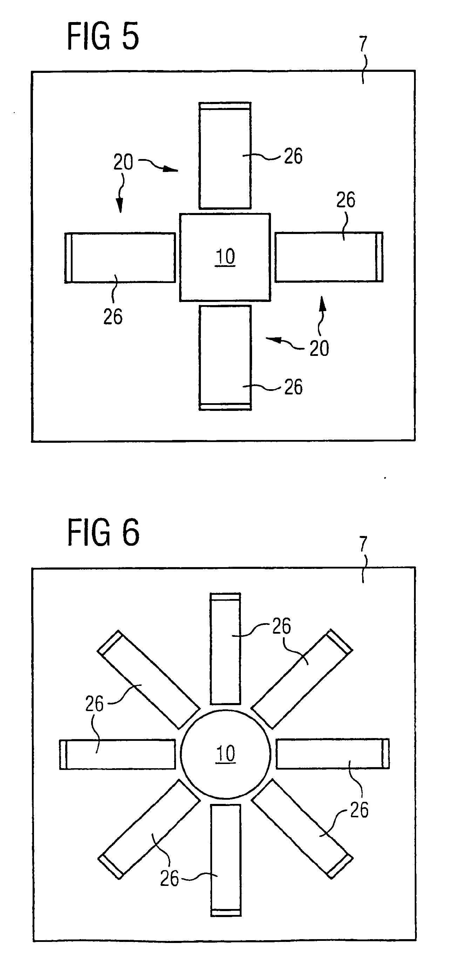

In der Nähe des äußeren Randes der kantenemittierenden Halbleiterlaserstruktur 21 befinden sich senkrecht zu den Schichten der kantenemittierenden Halbleiterlaserstruktur 21 verlaufende Endspiegel 31, die ausgehend von der Deckschicht 30 mindestens bis in die erste Mantelschicht 28, hier bis in die Bufferschicht 6 reichen. Diese sind beispielsweise nach dem Aufwachsen der kantenemittierenden Halbleiterlaserstruktur 21 mittels Ätzen (z.B. reaktives Ionenätzen) von entsprechenden Gräben und deren nachfolgendem Füllen mit hochreflektierendem Material hergestellt. Es sind jeweils zwei zueinander parallele Spiegel 31 auf gegenüberliegenden Seiten der Quantentopfstruktur 11 angeordnet (vgl. Figuren 5 und 6).

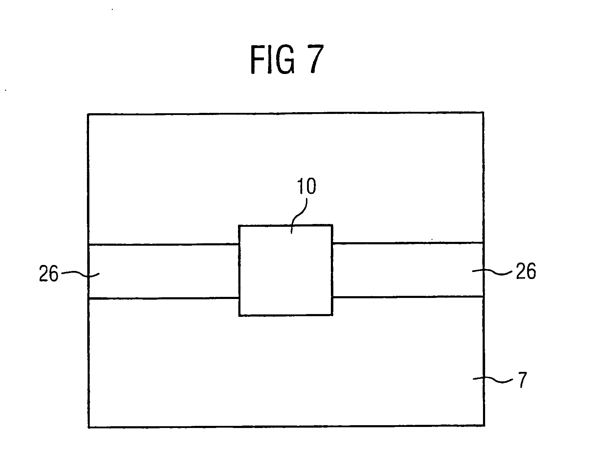

Alternativ können die Endspiegel in bekannter Weise durch Spalten des Wafers entlang von Kristallebenen hergestellt werden. Diese sind dann notwendigerweise nicht, wie in Figur 1 dargestellt, im Chip angeordnet, sondern durch die gespaltenen Chipseitenflächen gebildet (vgl. Figur 7).

Auf der freien Oberfläche der Deckschicht 30 und des Braggspiegels 3 befindet sich eine elektrisch isolierende Maskenschicht 7, beispielsweise eine Siliziumnitrid- eine Aluminiumoxid- oder eine Siliziumoxidschicht, mit der Strominjektionspfade 26 der kantenemittierenden Halbleiterlaserstruktur 21 definiert sind (vgl. Figuren 5 und 6). Auf der Maskenschicht 7 und, in deren Aussparungen für die Strominjektionspfade 26, auf der Deckschicht 30 ist eine p-Kontaktschicht 32, z.B. eine bekannte Kontaktmetallisierung, aufgebracht.

Für die Pumpquelle sind beispielsweise sechs symmetrisch sternförmig um den oberflächenemittierenden Laserbereich 15 angeordnete Streifenarrays mit fünfzehn Streifen (4µm Streifen, 10µm Pitch) und mit ca. 150µm aktiver Breite gewählt.

Vorzugsweise weisen die der strahlungserzeugenden Quantentopfstruktur 11 zugewandten Enden der Strominjektionspfade 26 zu dieser einen Abstand von 10µm - 50pm, besonders bevorzugt von ca. 30µm auf. Dadurch werden störende Leckströme und andere störende Einflüsse an den Grenzflächen zwischen der kantenemittierenden Halbleiterstruktur 21 und der oberflächenemittierenden Schichtenfolge 10, d.h. an den Einkoppelflächen für die Pumpstrahlung 2, reduziert.

Alle Strominjektionspfade 26 können mit einer gemeinsamen p-Kontaktschicht 32 versehen sein, wodurch die strahlungsemittierenden Bereiche der kantenemittierenden Struktur im Betrieb parallel geschaltet sind. Bei vorgesehener getrennter Ansteuerung dieser einzelnen strahlungsemittierenden Bereiche ist eine entsprechend strukturierte p-leitende erste Kontaktschicht 32 aufgebracht. Dadurch kann eine optimierte Pumplichtverteilung (z.B. ähnlich einem Gaußprofil) über den lateralen Querschnitt der oberflächenemittierenden Struktur erzeugt werden.

Zur Erzeugung von indexgeführten Pumpbereichen in der kantenemittierenden Struktur 21 können in dieser entlang den Strominjektionspfaden 26 zum Beispiel mittels Ätzen hergestellte Gräben ausgebildet sein (in den Figuren nicht dargestellt), die beispielsweise bis 0,5µm in die zweite Wellenleiterschicht 24 reichen. Dadurch wird eine verbesserte Wellenführung an den Rändern der Pumpbereiche erzielt.

Die von der Halbleiterstruktur abgewandte Hauptfläche 16 des Substrats 1 ist bis auf ein Austrittsfenster 8 für den Laserstrahl (angedeutet durch den Pfeil 5) mit einer n-leitenden zweiten Kontaktschicht 9, z.B. ebenfalls eine bekannte Kontakmetallisierung, versehen.

Die Hauptfläche 16 des Substrats ist vorzugsweise im Bereich des Austrittsfensters 8 entspiegelt, um Rückreflexionen in den Chip zu verringern.

Ein Laserresonator der oberflächenemittierenden Laserstruktur 10 kann aus dem Braggspiegel 3 und einem auf der gegenüberliegenden Seite des Substrats 1 angeordneten externen weiteren Spiegel (in Figur 1 nicht dargestellt) oder einem zwischen dem Substrat 1 und der Quantentopfstruktur 11 angeordnetem weiteren Braggspiegel gebildet sein.

Im Betrieb des Halbleiterchips wird in den durch die Strominjektionspfade 26 definierten Bereichen der kantenemittierenden Halbleiterstruktur 21, die die Pumpstrahlungsquelle 20 darstellt, Pumpstrahlung (angedeutet durch die Pfeile 2) erzeugt und in die Quantentopfstruktur 11 der oberflächenemittierenden Laserstruktur 10 eingekoppelt.

Bei ausreichender Rückreflexion an der Grenzfläche zwischen kantenemittierender 21 und oberflächenemittierender Struktur 10 und geeigneter Lage der Endspiegel 31 wird in der kantenemittierenden Struktur 21 Laserstrahlung erzeugt, was zu einer erhöhten Pumpeffizienz führt.

Vorzugsweise sind die Endspiegel 31 derart zueinander angeordnet, daß diese einen Laserresonator für zwei einander gegenüberliegende strahlungsemittierende Bereiche der kantenemittierenden Struktur 21 ausbilden. Die zwei gegenüberliegenden strahlungsemittierenden Bereiche sind dann nach dem Transparentpumpen der oberflächenemittierenden Laserstruktur 10 zu einem einzigen kohärent schwingenden Laser verkoppelt. Bei optimaler Verspiegelung der Endspiegel 31 steht dann bis auf Verluste an der Grenzfläche zwischen kantenemittierender 21 und oberflächenemittierender Struktur 10 die gesamte vom Pumplaser erzeugte optische Leistung als Pumpleistung zur Verfügung.

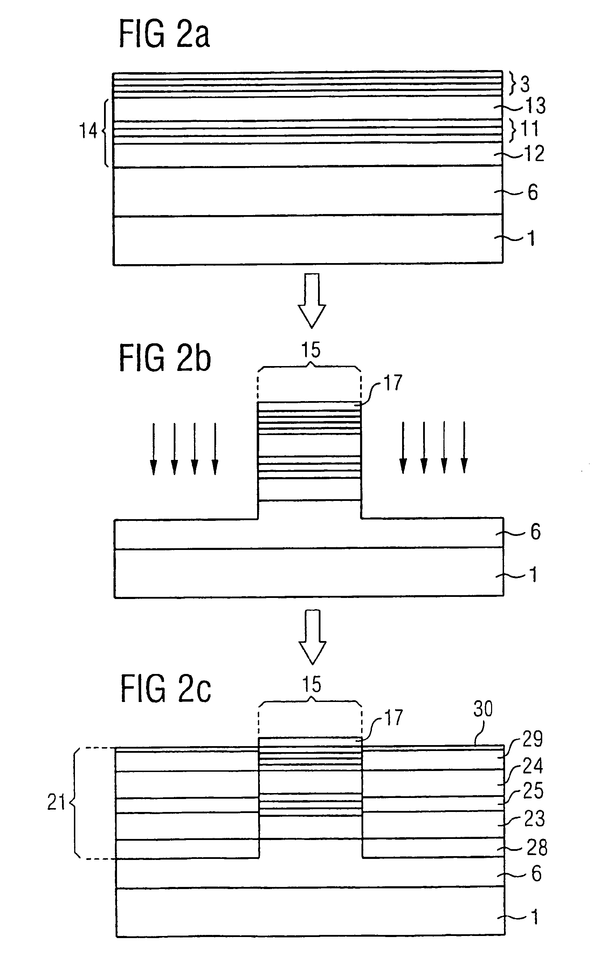

Bei dem in den Figuren 2a bis 2e schematisch dargestellten Verfahren zur Herstellung der Halbleitervorrichtung gemäß Figur 1 werden zunächst auf das Substrat 1 nacheinander die Bufferschicht 6, die erste Confinementschicht 12, die Quantentopfstruktur 11, die zweite Confinementschicht 13 und die Braggspiegelschichten 3 beispielsweise mittels MOVPE aufgebracht (Figur 2a).

Danach wird auf den als oberflächenemittierenden Laserbereichs 15 vorgesehenen Bereich dieser Schichtenfolge eine Ätzmaske 17 (z.B. eine Si-Nitridmaske) aufgebracht. Nachfolgend werden außerhalb des vorgesehenen oberflächenemittierenden Laserbereichs 15 die Braggspiegelschichten 3, die Confinementschichten 12 und 13, die Quantentopfstruktur 11 und teilweise die Bufferschicht 6 beispielsweise mittels Ätzen, z.B. Trockenätzen mittels Cl-Chemie, entfernt (Figur 2b).

Auf den freigelegten Bereich der Bufferschicht 6 werden dann die erste Mantelschicht 28, die erste Wellenleiterschicht 23, die aktive Schicht 25, die zweite Wellenleiterschicht 24, die zweite Mantelschicht 29 und die Deckschicht 30 nacheinander beispielsweise wiederum mittels MOVPE aufgebracht (Figur 2c).

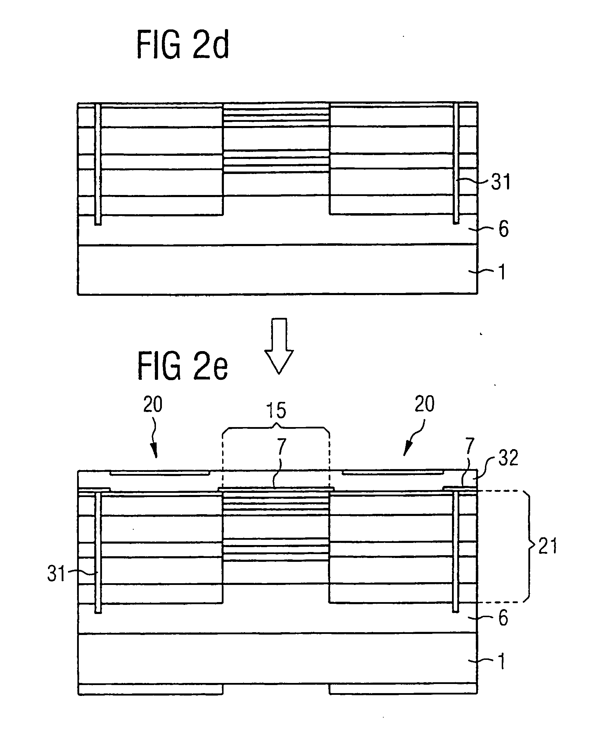

Beispielsweise mittels reaktivem Ionenätzen und geeigneter bekannter Maskentechnik werden dann in die zuletzt aufgebrachte kantenemittierende Struktur 21 Gräben für die Endspiegel 31 geätzt (vgl. Figur 2d), die nachfolgend mit reflexionssteigerndem Material beschichtet oder gefüllt werden. Weiterhin wir die Ätzmaske 17 entfernt.

Nachfolgend wird auf die Deckschicht 30 und den Braggspiegel 3 die elektrisch isolierende Maskenschicht 7 aufgebracht, bevor abschließend die p-Kontaktschicht 32 und die n-Kontaktschicht 9 hergestellt werden (Figur 2e).

Optional werden vor dem Aufbringen der isolierenden Maskenschicht 7 die oben in Verbindung mit Figur 1 beschriebenen Gräben zur Erzeugung von indexgeführten Pumplasern mittels Ätzen hergestellt.

Zur Verminderung von Strahlungsverlusten wird vorzugsweise das Substrat 1 nach der MOVPE beispielsweise auf unter 100µm gedünnt oder vollständig entfernt.

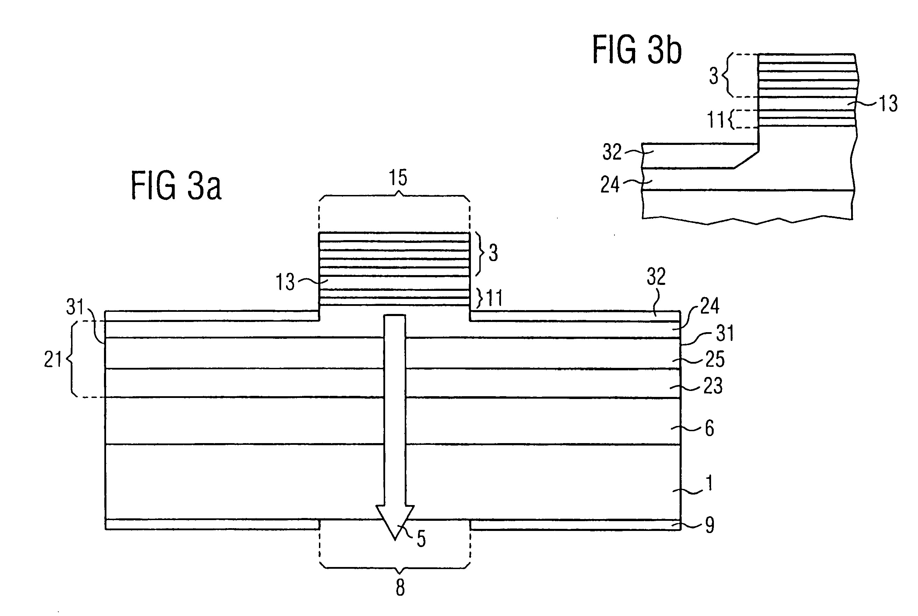

Bei dem Ausführungsbeispiel gemäß Figur 3a befindet sich auf dem Substrat 1 zunächst ganzflächig eine Bufferschicht 6 und eine kantenemittierende Halbleiterlaserstruktur 21, bei der zwischen einer ersten 23 und einer zweiten Wellenleiterschicht 24 eine aktive Schicht 25 angeordnet ist.

In einem vorgesehenen Laserbereich 15 über der Mitte des Substrats 1 ist auf der zweiten Wellenleiterschicht 24 eine oberflächenemittierende Quantentopfstruktur 11, gefolgt von einer Confinementschicht 13 und einer Braggspiegel-Schichtenfolge 3, aufgewachsen.

Im Bereich um den Laserbereich 15 ist auf die zweite Wellenleiterschicht 24 oder ggf. auf eine auf dieser aufgebrachten hochdotierten Deckschicht eine elektrisch isolierende Maskenschicht 7 aufgebracht, die Ausnehmungen für Strominjektionspfade 26 der die kantenemittierenden Struktur 21 aufweist (vgl. Figur 7). Auf der elektrisch isolierenden Maskenschicht 7 und in deren Ausnehmungen auf der zweiten Wellenleiterschicht bzw. auf der Deckschicht befindet sich eine erste Kontaktschicht 32 und auf der dieser gegenüberliegenden Seite des Substrats 1 ist eine zweite Kontaktschicht 9 mit einem Austrittsfenster 8 für den Laserstrahl (angedeutet durch den Pfeil 5) angeordnet.

Zur Erzeugung von indexgeführten Pumpbereichen in der kantenemittierenden Struktur 21 können in der zweiten Wellenleiterschicht 24 entlang den Strominjektionspfaden 26 zum Beispiel mittels Ätzen hergesetellte Gräben ausgebildet sein (in den Figuren nicht dargestellt). Dadurch wird eine verbesserte Wellenführung an den Rändern der Pumpbereiche erzielt.

Als Endspiegel 31 der kantenemittierenden Struktur 21 sind hier beispielsweise gespaltene Flanken des Chips vorgesehen.

Im Betrieb wird in der kantenemittierenden Laserstruktur Pumplaserstrahlung erzeugt, von der ein Teil in die darüberliegende Quantentopfstruktur 11 eingekoppelt wird.

Um die Einkopplung zu fördern, befindet sich die aktive Schicht 25 asymmetrisch in dem von den zwei Wellenleiterschichten 23,24 gebildeten Wellenleiter. Alternativ oder zusätzlich kann zum gleichen Zweck der Brechungsindex der zweiten Wellenleiterschicht 24 höher sein als der der ersten Wellenleiterschicht 23 und/oder kann die zweite Wellenleiterschicht zum Laserbereich 15 hin in Richtung Quantentopfstruktur 11 hochgezogen sein (vgl. Figur 3b).

Als Materialien für die verschiedenen Schichten lassen sich hier beispielhaft die für die entsprechenden Schichten des Ausführungsbeispieles gemäß Figur 1 angegebenen Materialien verwenden.

Ein Laserresonator der oberflächenemittierenden Laserstruktur 10 kann auch bei diesem Ausführungsbeispiel aus dem Braggspiegel 3 und einem auf der gegenüberliegenden Seite des Substrats 1 angeordneten externen weiteren Spiegel (in der Figur 3a nicht dargestellt) oder einem zwischen dem Substrat 1 und der Quantentopfstruktur 11 angeordnetem weiteren Braggspiegel gebildet sein.

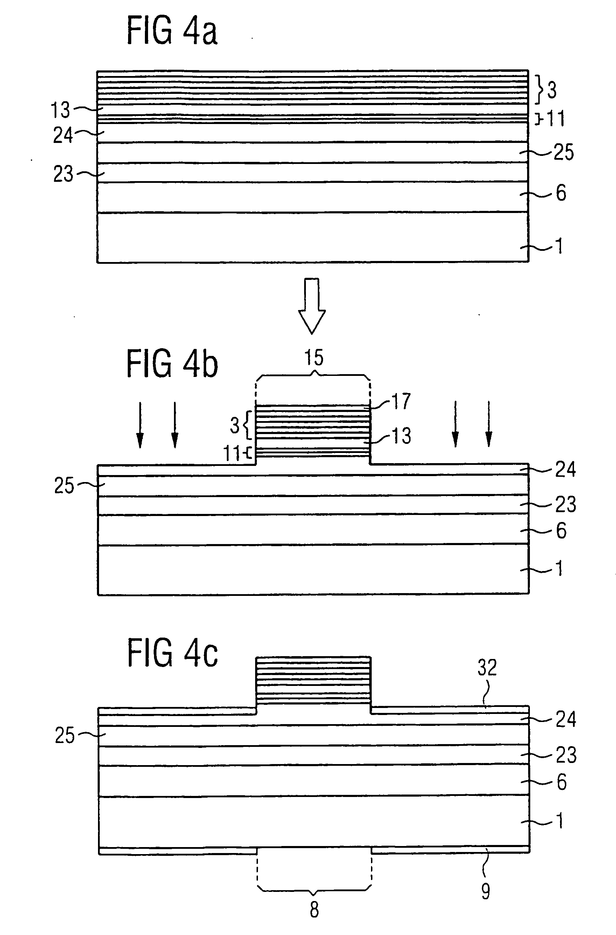

Bei dem in den Figuren 4a bis 4c schematisch dargestellten Verfahren zum Herstellen einer Vorrichtung gemäß dem Auführungsbeispiel von Figur 3a wird zunächst auf das Substrat 1 eine Bufferschicht 6 aufgebracht. Auf dieser wird nachfolgend die erste Wellenleiterschicht 23, die aktive Schicht 25 und die zweite Wellenleiterschicht 24 nacheinander aufgewachsen. Danach wird auf die zweite Wellenleiterschicht 24 die Quantentopfstruktur 11, gefolgt von der Confinementschicht 13 und der Braggspiegelschicht 3 aufgewachsen (Figur 4a). Diese Schichten werden beispielsweise mittels MOVPE hergestellt.

Nachfolgend wird auf den als Laserbereich 15 vorgesehenen Teilbereich der aufgewachsenen Schichtenfolge eine Ätzmaske 17 aufgebracht und die Braggspiegelschicht 3, die Confinementschicht 13, die Quantentopfstruktur 11 und teilweise die zweite Wellenleiterschicht 24 außerhalb der Laserbereichs 15 mittels Ätzen entfernt (Figur 4b).

Danach wird zur Definition der Strominjektionspfade 26 die elektrisch isolierende Maskenschicht 7 auf die zweite Wellenleiterschicht 24 aufgebracht, bevor dann die erste Kontaktschicht 32 abgeschieden wird.

Nachfolgend wird auf die der Halbleiterschichtenfolge gegenüberliegende Hauptfläche des Substrats 1 die zweite Kontaktschicht 9 mit einem Austrittsfenster 8 aufgebracht (Figur 4c).

Zur Verminderung von Strahlungsverlusten wird auch hier vorzugsweise das Substrat 1 nach der MOVPE beispielsweise auf unter 100µm gedünnt oder vollständig entfernt.

Die erfindungsgemäßen sogenannten Scheibenlaser werden vorzugsweise mit dem Braggspiegel nach unten auf eine Wärmesenke gelötet. Eine Elektrode befindet sich auf der Wärmesenke, die zweite wird durch Bondung auf der Scheibenlaser-Oberfläche erzeugt.

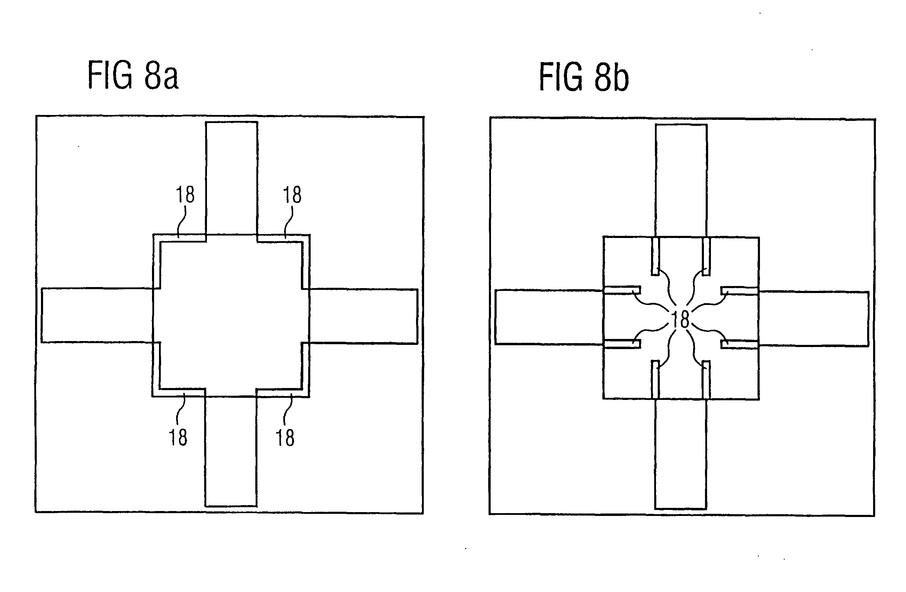

Um störende Quermoden (= Moden parallel zum Substrat - whispering modes) zu verhindern, sind im Randbereich und/oder in Ätzstrukturen der oberflächenemittierenden Halbleiterlaserschichtenfolge 15 Absorberschichten 18 angeordnet (vgl. Figuren 8a und 8b). Geeignete Absorbermaterialien für derartige Anwendungen sind bekannt und werden von daher an dieser Stelle nicht näher erläutert.

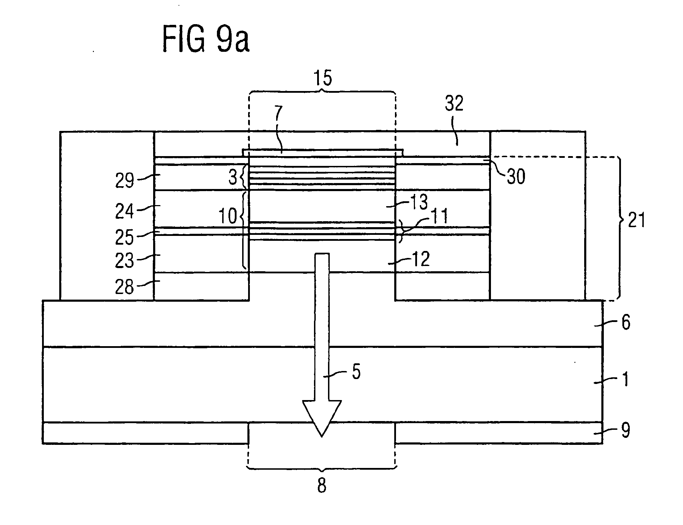

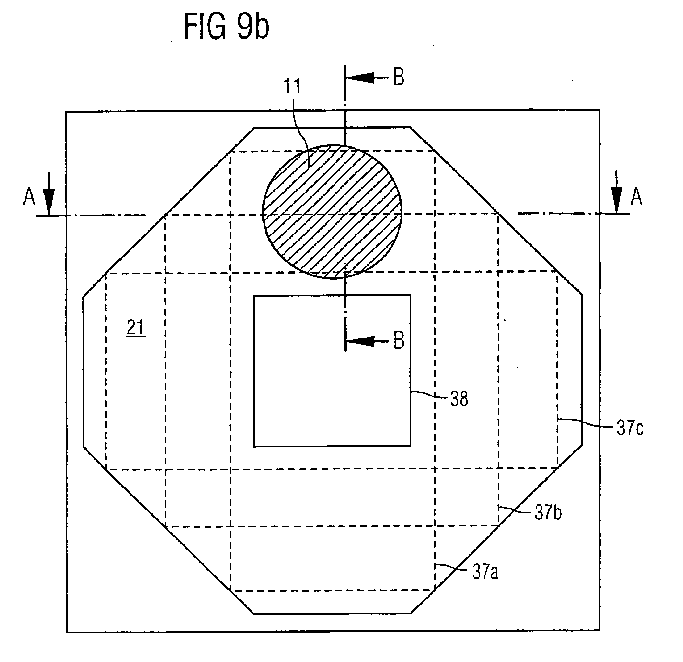

In Figur 9a ist ein Schnitt durch eine optisch gepumpte oberflächenemittierende Halbleiterlaservorrichtung mit einem Ringlaser als Pumpstrahlungsquelle dargestellt. Die Abfolge der einzelnen Halbleiterschichten entspricht im wesentlichen der in Figur 1 gezeigten Halbleiterlaservorrichtung.

Im Unterschied zu der in Figur 1 dargestellten Halbleitervorrichtung ist die kantenemittierende Halbleiterstruktur 21, umfassend die ersten Mantelschicht 28 (z.B. n-GaAl_{0.65}As), die erste Wellenleiterschicht 23 (z.B. n-GaAl_{0.1}As), die aktive Schicht 25 (z.B. InGaAs-SQW), die zweite Wellenleiterschicht 24 (z.B. p-GaAl_{0.1}As) und die zweite Mantelschicht 29 (z.B. p-GaAl_{0.65}As), als Ringlaser ausbildet.

Dies verdeutlicht die in Figur 9b gezeigt eine Aufsicht auf den Halbleiterkörper. Die Schnittdarstellung gemäß Figur 9a entspricht einem senkrechten Schnitt entlang der Linie A-A.

Die kantenemittierende Halbleiterstruktur 21 weist in der Aufsicht eine achteckige Form mit vierzähliger Rotationssymmetrie sowie eine quadratische zentrale Aussparung 38 auf. Die zu pumpende, in der Aufsicht kreisförmige Quantentopfstruktur 11 ist vollständig innerhalb des so gebildeten Achteckrings angeordnet. Dieser Achteckring bildet einen Ringresonator in Form eines totalreflektierenden, geschlossenen Wellenleiters.

Im Betrieb schwingen in diesem Wellenleiter zyklisch umlaufende Ringmoden, beispielhaft dargestellt anhand der Moden 37a,b,c, an, die die Quantentopfstruktur 11 optisch pumpen. Aufgrund der Totalreflexion an den Außenflächen sind die Auskoppelverluste bei diesem Ausführungsbeispiel äußerst gering, so daß mit Vorteil das gesamte resonatorinterne Strahlungsfeld zum Pumpen der Quantentopfstruktur 11 zur Verfügung steht.

Aufgrund der gezeigten Formgebung des Achteckrings sind die Ringmoden 37a, 37b und 37c im wesentlichen gleichberechtigt und breiten sich gleichförmig aus. Somit ergibt sich in radialer Richtung (entlang der Linie B-B) ein weitgehend homogenes Strahlungsfeld und entsprechend eine weitgehend gleichmäßige Pumpdichte in der zu pumpenden Quantentopfstruktur 11.

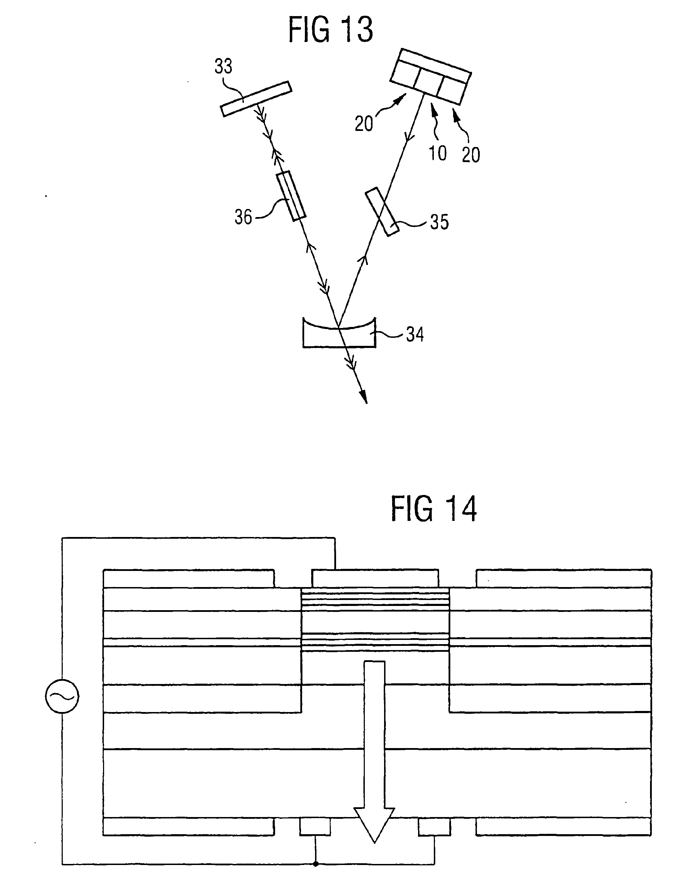

Der für einen Laserbetrieb der oberflächenemittierenden Halbleiterlaserstruktur 10 erforderliche zweite Spiegel ist bei dem gezeigten Ausführungsbeispiel nicht in den Halbleiterkörper integriert, sondern als externer Spiegel vorgesehen (vgl. auch Figur 13). Alternativ kann dieser zweite Spiegel auch in ähnlicher Weise wie der Spiegel 3 in nicht dargestellter Weise in dem Halbleiterkörper ausgebildet sein. In diesem Fall wäre der zweite Spiegel beispielsweise innerhalb des vorgesehenen Laserbereichs 15 zwischen der Bufferschicht 6 und der Quantentopfstruktur 11 anzuordnen.

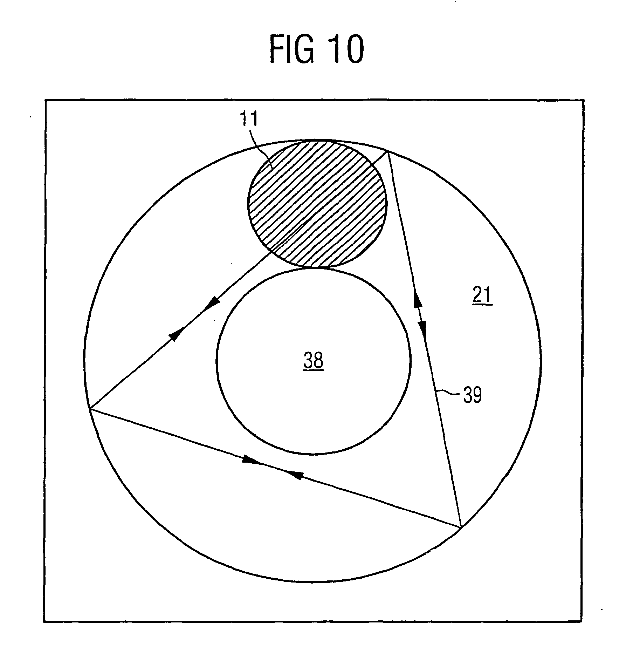

In Figur 10 ist ein weiteres Ausführungsbeispiel einer erfindungsgemäßen Halbleiterlaservorrichtung in Aufsicht gezeigt. Im Unterschied zu dem vorangehend beschriebenen Ausführungsbeispiel ist hier der totalreflektierende Wellenleiter als Kreisring gebildet. Die zu pumpende Quantentopfstruktur 11 ist vollständig innerhalb des Ringbereichs angeordnet.

Innerhalb des kreisringförmigen Resonators können eine Vielzahl von Ringmoden anschwingen. Die dargestellt Mode 39 zeigt lediglich ein mögliches Beispiel. Die Quantentopfstruktur 11 wird daneben von einer Vielzahl weiterer Moden mit hoher Effizienz gepumpt.

Wie sich aus Figur 10 ergibt, kann zur Vereinfachung auch auf die zentrale Aussparung 38 verzichtet werden, so daß der Resonator eine Vollkreisfläche als Querschitt aufweist. Dadurch wird mit Vorteil der Herstellungsaufwand reduziert. Allerdings können dann bis zu einem gewissen Grad Moden anschwingen, die durch das Resonatorzentrum verlaufen. Diese Moden werden an der Resonatorbegrenzung nicht totalreflektiert und besitzen daher vergleichsweise hohe Auskoppelverluste, die letztendlich die Pumpeffizienz verringern.

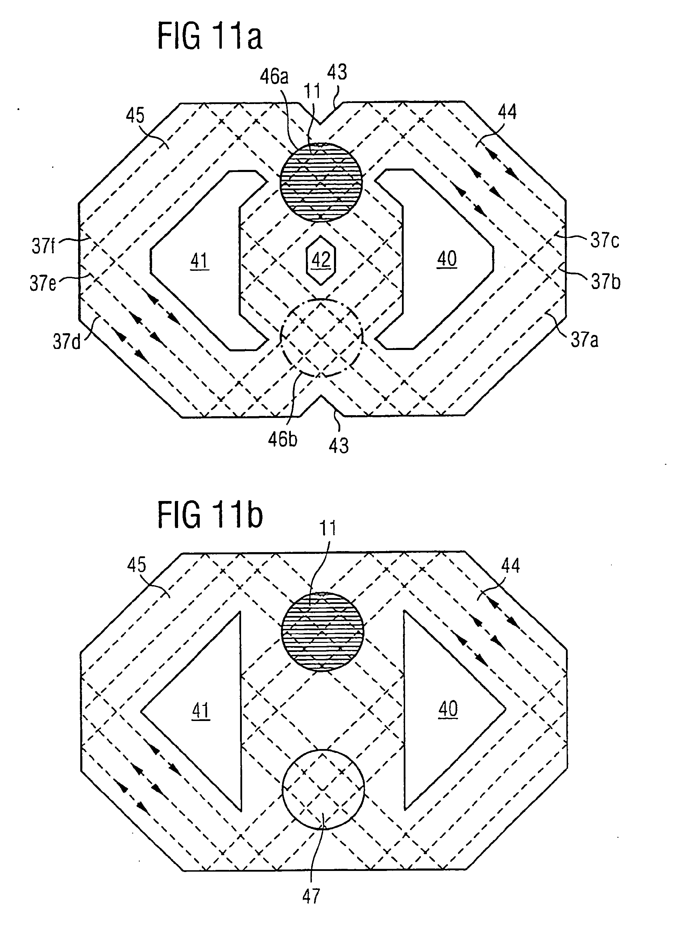

In Figur 11a ist ein weiteres Ausführungsbeispiel der Erfindung gezeigt, bei dem die Quantentopfstruktur 11 von zwei voneinander unabhängigen Ringlasern gepumpt wird. Diese sind prinzipiell wie die Ringlaser des ersten Ausführungsbeispiels aufgebaut.

Die zugehörigen Wellenleiter 44,45 kreuzen sich in zwei Bereichen 46a,b, wobei im Bereich 46a die zu pumpende Quantentopfstruktur 11 angeordnet ist. Mittels dieser Anordnung mit zwei Ringlasern wird die Pumpdichte in der Quantentopfstruktur 11 weiter erhöht. Die wesentlichen Pumpmoden sind wiederum beispielhaft anhand der Moden 37a,b,c,d,e,f dagestellt. Mit Vorteil ergibt sich wie bei dem ersten Ausführungbeispiel dargelegt auch hier wieder eine weitgehend homogene Pumpdichte.

In Figur 11b ist eine vorteilhafte Variante der in Figur 11a dargestellten Anordnung gezeigt, die sich insbesondere dadurch auszeichnet, daß die Formgebung der sich kreuzenden, ringförmigen Wellenleiter 44 und 45 vereinfacht ist. Dazu sind die Querschnitte der zentralen Ausnehmungen 40 und 41 auf Dreiecke reduziert. Auf die zentrale Ausnehmung 42 und die in Figur 11a dargestellten seitlichen Ausnehmungen 43 wird verzichtet. Durch diese Vereinfachung wird mit Vorteil der Herstellungsaufwand verringert, ohne die Laserfunktion wesentlich zu beeinträchtigen.

Weitergehend könnte auch, wie in Figur 11b angedeutet, eine zweite Quantentopfstruktur 47 in dem zweiten Kreuzungsbereich 46b der beiden Ringlaser ausgebildet sein.

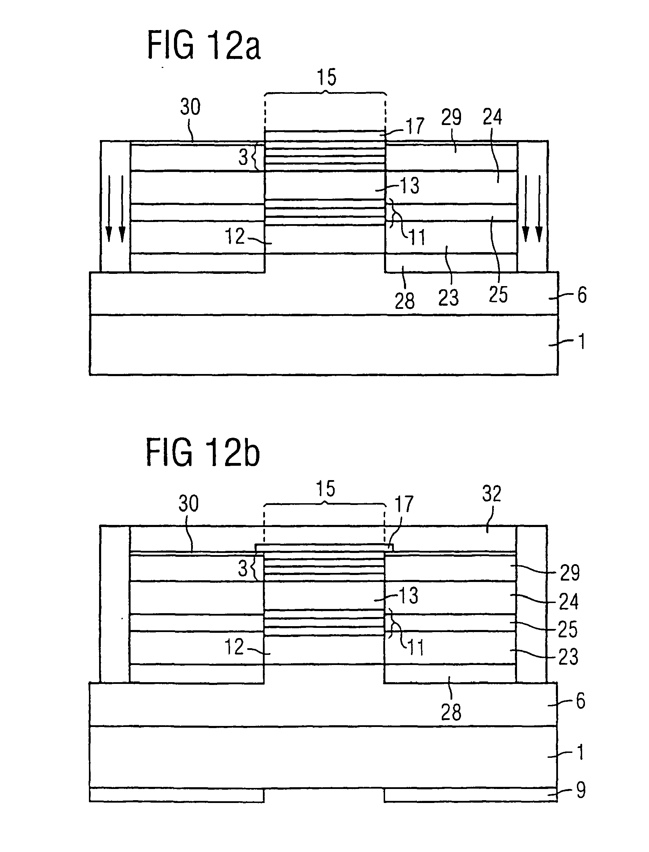

In Figur 12 sind schematisch zwei Verfahrensschritte zur Herstellung einer Halbleiterlaservorrichtung gezeigt.

Das Verfahren beginnt wie bereits beschrieben und in den Figuren 2a, 2b und 2c dargestellt, mit der Aufbringung der Bufferschicht 6, der ersten Confinementschicht 12, der Quantentopfstruktur 11, der zweiten Confinementschicht 13 und der Braggspiegelschichten 3 auf ein Substrat 1, beispielsweise mittels MOVPE. Danach wird auf den als oberflächenemittierenden Laserbereichs 15 vorgesehenen Bereich dieser Schichtenfolge eine Ätzmaske 17 aufgebracht und der Stapel aus Braggspiegelschichten 3, Confinementschichten 12 und 13, Quantentopfstruktur 11 und Teilen der Bufferschicht 6 außerhalb des vorgesehenen oberflächenemittierenden Laserbereichs 15 entfernt. Auf den freigelegten Bereich der Bufferschicht 6 werden dann die erste Mantelschicht 28, die erste Wellenleiterschicht 23, die aktive Schicht 25, die zweite Wellenleiterschicht 24, die zweite Mantelschicht 29 und die Deckschicht 30 nacheinander beispielsweise wiederum mittels MOVPE aufgebracht (nicht dargestellt, vgl. Figur 2a,b,c).

Anschließend werden gemäß Figur 12a die Außenbereiche und der Zentralbereich der Halbleiterstruktur zur Bildung des totalreflektierenden, geschlossenen Wellenleiters abgetragen. Dies kann beispielsweise durch reaktives Ionenätzen unter Verwendung einer geeigneten, bekannten Maskentechnik erfolgen.

Die so hergestellten Seitenflächen der kantenemittierenden Halbleiterstruktur erfordern keine optische Vergütung und bilden einen nahezu verlustfreien Ringlaserresonator.

Abschließend wird die Ätzmaske 17 entfernt, auf den Braggspiegel 3 die elektrisch isolierende Maskenschicht 7 aufgebracht und die Oberfläche mit einer p-Kontaktschicht 32 abgedeckt. Das Substrat wird mit n-Kontaktflächen 9 versehen (Figur 12b).

Die erfindungsgemäße Halbleiterlaservorrichtung eignet sich insbesondere zur Anwendung in einem externen Resonator mit einem externen Spiegel 33 und einen teildurchlässigen konkaven Umlenkspiegel 34, in dem sich ein frequenzselektives Element 35 und/oder ein Frequenzverdoppler 36 befindet (vgl. Figur 13).

Vorteilhafterweise kann die erfindungsgemäße Halbleiterlaservorrichtung über Modulation der Pumpquelle (durch Modulation des Pumpstromes) oder über Kurzschlußschaltung der oberflächenemittierenden Halbleiterlaserschichtenfolge (vgl. Figur 14) moduliert werden.

Die oben beschriebenen Strukturen lassen sich nicht nur im beispielhaft verwendeten InGaAlAs-System, sondern beispielsweise auch im InGaN-, InGaAsP- oder im InGaA1P-System verwenden.

Bei einem Scheibenlaser im InGaN-System für eine Emission bei 470 nm bestehen die Quantenwells beispielsweise aus InGaN für 450nm-Emission, die Confinementschichten aus InGaN mit reduzierter Brechzahl und die Braggspiegel aus einem InGaAlN-System. Die Pumplaserstruktur weist einen aktiven Bereich mit Quantenwells aus InGaN für Emission bei ca. 400nm, sowie Wellenleiterschichten und Mantelschichten aus GaAlN auf, bei denen die gewünschten Brechzahlen über Variation des Al-Gehalts eingestellt werden.

## Patentansprüche

1. Optisch gepumpte oberflächenemittierende Halbleiterlaservorrichtung mit mindestens einer strahlungserzeugenden Quantentopfstruktur (11) und mindestens einer Pumpstrahlungsquelle (20) zum optischen Pumpen der Quantentopfstruktur (11), bei der die Pumpstrahlungsquelle (20) eine kantenemittierende Halbleiterstruktur (21) aufweist,
**dadurch gekennzeichnet, daß**
die strahlungserzeugende Quantentopfstruktur (11) und die kantenemittierende Halbleiterstruktur (21) jeweils eine Halbleiterschichtenfolge aufweisen, die auf einem gemeinsamen Substrat (1) epitaktisch und nacheinander aufgewachsen und übereinander angeordnet sind.

2. Halbleiterlaservorrichtung nach Anspruch 1,
**dadurch gekennzeichnet, daß**
die Quantentopfstruktur (11) von der kantenemittierenden Halbleiterstruktur (21) umschlossen ist, in der mittels mindestens eines Strominjektionspfades (26) auf einer Oberfläche der Halbleiterlaserstruktur (21) mindestens ein gewinngeführter strahlungsemittierender aktiver Bereich ausgebildet ist, der als Pumpstrahlungsquelle (20) dient.

3. Halbleiterlaservorrichtung nach Anspruch 1,
**dadurch gekennzeichnet, daß**
die Quantentopfstruktur (11) von der kantenemittierenden Halbleiterstruktur (21) umschlossen ist, in der mittels mindestens eines Strominjektionspfades (26) auf einer Oberfläche der Halbleiterstruktur in Verbindung mit entlang dem Strominjektionspfad (26) ausgebildeten Gräben in der Halbleiterstruktur (21) mindestens ein indexgeführter strahlungsemittierender aktiver Bereich definiert ist, der als Pumpstrahlungsquelle (20) dient.

4. Halbleiterlaservorrichtung nach Anspruch 2 oder 3
**dadurch gekennzeichnet, daß**
die der strahlungserzeugenden Quantentopfstruktur (11) zugewandten Enden der Strominjektionspfade (26) zu dieser einen Abstand von 10µm - 50µm aufweisen.

5. Halbleiterlaservorrichtung nach einem der Ansprüche 1 bis 4,
**dadurch gekennzeichnet, daß**
zwei Pumpstrahlungsquellen (20) auf einander gegenüberliegenden Seiten der Quantentopfstruktur (11) angeordnet sind, die im Betrieb Pumpstrahlung (2) in die Quantentopfstruktur (11) senden.

6. Halbleiterlaservorrichtung nach einem der Ansprüche 1 bis 5,
**dadurch gekennzeichnet, daß**
eine Mehrzahl von Pumpstrahlungsquellen (20) sternförmig um die Quantentopfstruktur (11) angeordnet sind, die im Betrieb Pumpstrahlung (2) in die Quantentopfstruktur (11) senden.

7. Halbleiterlaservorrichtung nach Anspruch 5 oder 6,
**dadurch gekennzeichnet, daß**
jeweils zwei auf einander gegenüberliegenden Seiten der Quantentopfstruktur (11) angeordnete Pumpstrahlungsquellen (20) zusammen eine Laserstruktur zum optischen Pumpen mittels Laserstrahlung bilden.

8. Halbleiterlaservorrichtung nach einem der Ansprüche 1 bis 7,
**dadurch gekennzeichnet, daß**
die Pumpstrahlungsquelle (20) mindestens einen Ringlaser aufweist.

9. Halbleiterlaservorrichtung nach Anspruch 8,
**dadurch gekennzeichnet, daß**
die Quantentopfstruktur (11) innerhalb des Resonators des Ringlasers angeordnet ist.

10. Halbleiterlaservorrichtung nach Anspruch 8 oder 9,
**dadurch gekennzeichnet, daß**
der Resonator des Ringlasers von einem ringförmig geschlossenen Wellenleiter gebildet ist.

11. Halbleiterlaservorrichtung nach einem der Ansprüche 8 bis 10,
**dadurch gekennzeichnet, daß**
die kantenemittierende Halbleiterstruktur (21) von einem Medium umgeben ist, dessen Brechungsindex geringer ist als der Brechungsindex der kantenemittierenden Halbleiterstruktur (21).

12. Halbleiterlaservorrichtung nach einem der Ansprüche 8 bis 11,
**dadurch gekennzeichnet, daß**
die kantenemittierende Halbleiterstruktur (21) von Luft, einem anderen gasförmigen Medium oder einem Dielektrikum umgeben ist.

13. Halbleiterlaservorrichtung nach einem der Ansprüche 8 bis 12,
**dadurch gekennzeichnet, daß**
die kantenemittierende Halbleiterstruktur (21) als zylindrischer Körper mit kreisförmigem oder kreisringförmigem Querschnitt gebildet ist.

14. Halbleiterlaservorrichtung nach einem der Ansprüche 8 bis 12,
**dadurch gekennzeichnet, daß**
die kantenemittierende Halbleiterstruktur (21) als prismatischer Körper mit einem Querschnitt in Form eines Vielecks oder eines Vieleckrings gebildet ist.

15. Halbleiterlaservorrichtung nach einem der Ansprüche 1 bis 14,
**dadurch gekennzeichnet, daß**
die kantenemittierende Halbleiterstruktur (21) mindestens eine zwischen eine erste (23) und eine zweite Wellenleiterschicht (24) eingebettete aktive Schicht (25) aufweist, die wiederum zwischen einer ersten (28) und einer zweiten Mantelschicht (29) eingebettet sind.

16. Halbleiterlaservorrichtung nach Anspruch 15,
**dadurch gekennzeichnet, daß**
die Grenzfläche zwischen kantenemittierender Halbleiterstruktur (21) und Quantentopfstruktur (11) zumindest teilweise reflektierend ist.

17. Halbleiterlaservorrichtung nach einem der Ansprüche 1 bis 16,
**dadurch gekennzeichnet, daß**
die kantenemittierende Halbleiterstruktur (21) mehrere aktive Schichten (25) aufweist, die mittels Tunnelübergänge in Reihe geschaltet sind.

18. Halbleiterlaservorrichtung nach Anspruch 1 bis 17,
**dadurch gekennzeichnet, daß**
die strahlungsemittierende Quantentopfstruktur (11) und die Pumpstrahlungsquelle (20) übereinander auf dem Substrat (1) angeordnet sind und daß die Quantentopfstruktur (11) an die kantenemittierende Halbleiterstruktur (21) optisch gekoppelt ist, so daß im Betrieb der Halbleiterlaservorrichtung Pumpstrahlung (2) in die Quantentopfstruktur (11) geführt wird.

19. Halbleiterlaservorrichtung nach Anspruch 1 bis 18,
**dadurch gekennzeichnet, daß**
die kantenemittierende Halbleiterstruktur (21) eine erste Wellenleiterschicht (23) und eine vom Substrat (1) gesehen dieser nachgeordnete zweite Wellenleiterschicht (24) aufweist, zwischen denen eine aktive Schicht (25) angeordnet ist und
daß die Quantentopfstruktur (11) auf der zweiten Wellenleiterschicht (24) epitaktisch aufgewachsen ist, nur einen Teilbereich der kantenemittierenden Halbleiterstruktur (21) überdeckt und an diese optisch angekoppelt ist, so daß zumindest ein Teil der in der kantenemittierenden Halbleiterstruktur (21) erzeugten Pumpstrahlung (2) in die Quantentopfstruktur (11) geführt wird.

20. Halbleiterlaservorrichtung nach Anspruch 19,
**dadurch gekennzeichnet, daß**
in der kantenemittierenden Halbleiterstruktur (21) mittels mindestens eines entsprechend strukturierten Strominjektionspfades (26) auf der Oberfläche der zweiten Wellenleiterschicht (24) mindestens ein gewinngeführter strahlungsemittierender aktiver Bereich ausgebildet ist, der als Pumpstrahlungsquelle (20) dient.

21. Halbleiterlaservorrichtung nach Anspruch 19,
**dadurch gekennzeichnet, daß**
in der kantenemittierenden Halbleiterstruktur (21) mittels mindestens eines entsprechend strukturierten Strominjektionspfades (26) auf der Oberfläche der zweiten Wellenleiterschicht (24) in Verbindung mit entsprechend geätzten Gräben in der zweiten Wellenleiterschicht (24) mindestens ein indexgeführter strahlungsemittierender aktiver Bereich ausgebildet ist, der als Pumpstrahlungsquelle (20) dient.

22. Halbleiterlaservorrichtung nach einem der Ansprüche 19 bis 21,
**dadurch gekennzeichnet, daß**
der Brechungsindex der zweiten Wellenleiterschicht (24) größer ist als der Brechungsindex der ersten Wellenleiterschicht (23).

23. Halbleiterlaservorrichtung nach einem der Ansprüche 19 bis 22,
**dadurch gekennzeichnet, daß**
die aktive Schicht (25) asymmetrisch in dem von den beiden Wellenleiterschichten (23,24) ausgebildeten Wellenleiter plaziert ist.

24. Halbleiterlaservorrichtung nach einem der Ansprüche 1 bis 23,
**dadurch gekennzeichnet, daß**
das Substrat (1) aus einem Material besteht, das für den in der Halbleiterlaservorrichtung erzeugten Laserstrahl (5) durchlässig ist und daß
auf der vom Substrat (1) abgewandten Seite der Quantentopfstruktur (11) eine Resonatorspiegelschicht (3), insbesondere ein Bragg-Reflektor mit möglichst hohem Reflexionskoeffizienten, aufgebracht ist.

25. Verfahren zum Herstellen einer optisch gepumpten oberflächenemittierenden Halbleiterlaservorrichtung, das folgende Verfahrensschritte aufweist:
a) Aufbringen einer kantenemittierenden Halbleiterschichtenfolge (21) auf ein Substrat (1);
b) Aufbringen einer oberflächenemittierenden Halbleiterlaserschichtenfolge (14) mit mindestens einer Quantentopfstruktur (11) auf die kantenemittierende Halbleiterschichtenfolge (21) ;
c) Entfernen der oberflächenemittierenden Halbleiterlaserschichtenfolge (14) außerhalb des vorgesehenen Laserbereichs (15), und
d) Ausbilden von mindestens einem Strominjektionspfad (26) in der kantenemittierenden Halbleiterschichtenfolge (21).

26. Verfahren nach Anspruch 25,
bei dem die Schritte a) bis c) folgende Einzelschritte aufweisen:
aa) Aufbringen einer Bufferschicht (6) auf das Substrat (1) ;
ab) Aufbringen einer ersten Wellenleiterschicht (23), einer aktiven Schicht (25) und einer zweiten Wellenleiterschicht (24) nacheinander auf die Bufferschicht (6),
ba) Aufbringen einer ersten Confinementschicht (12) auf die zweite Wellenleiterschicht (24);
bb) Aufbringen einer für einen oberflächenemittierenden Halbleiterlaser geeigneten Quantentopfstruktur (11) auf die erste Confinementschicht (12);
bc) Aufbringen einer zweiten Confinementschicht (13) auf die Quantentopfstruktur (11);
ca) Entfernen der Confinementschichten (12,13) und der Quantentopfstruktur (11) und teilweise der zweiten Wellenleiterschicht (24) außerhalb des vorgesehenen oberflächenemittierenden Laserbereichs (15).

## Claims

1. Optically pumped surface-emitting semiconductor laser device having at least one radiation-generating quantum well structure (11) and at least one pump radiation source (20) for optically pumping the quantum well structure (11), in which the pump radiation source (20) has an edge-emitting semiconductor structure (21),
**characterized in that**
the radiation-generating quantum well structure (11) and the edge-emitting semiconductor structure (21) in each case have a semiconductor layer sequence, which are grown epitaxially and one after the other on a common substrate (1) and are arranged one above the other.

2. Semiconductor laser device according to Claim 1,
**characterized in that**
the quantum well structure (11) is enclosed by the edge-emitting semiconductor structure (21), in which at least one gain-guided radiation-emitting active region that serves as pump radiation source (20) is formed by means of at least one current injection path (26) on a surface of the semiconductor laser structure (21).

3. Semiconductor laser device according to Claim 1,
**characterized in that**
the quantum well structure (11) is enclosed by the edge-emitting semiconductor structure (21), in which at least one index-guided radiation-emitting active region that serves as pump radiation source (20) is defined by means of at least one current injection path (26) on a surface of the semiconductor structure in conjunction with trenches formed along the current injection path (26) in the semiconductor structure (21).

4. Semiconductor laser device according to Claim 2 or 3,
**characterized in that**
those ends of the current injection paths (26) which face the radiation-generating quantum well structure (11) are at a distance of 10 µm - 50 µm from the latter.

5. Semiconductor laser device according to one of Claims 1 to 4,
**characterized in that**
two pump radiation sources (20) are arranged on mutually opposite sides of the quantum well structure (11), which emit pump radiation (2) into the quantum well structure (11) during operation.

6. Semiconductor laser device according to one of Claims 1 to 5,
**characterized in that**
a plurality of pump radiation sources (20) are arranged in star-shaped fashion around the quantum well structure (11), which emit pump radiation (2) into the quantum well structure (11) during operation.

7. Semiconductor laser device according to Claim 5 or 6,
**characterized in that**
in each case two pump radiation sources (20) which are arranged on mutually opposite sides of the quantum well structure (11) together form a laser structure for optical pumping by means of laser radiation.

8. Semiconductor laser device according to one of Claims 1 to 7,
**characterized in that**
the pump radiation source (20) has at least one ring laser.

9. Semiconductor laser device according to Claim 8,
**characterized in that**
the quantum well structure (11) is arranged within the resonator of the ring laser.

10. Semiconductor laser device according to Claim 8 or 9,
**characterized in that**
the resonator of the ring laser is formed by an annularly closed waveguide.

11. Semiconductor laser device according to one of Claims 8 to 10,
**characterized in that**
the edge-emitting semiconductor structure (21) is surrounded by a medium whose refractive index is less than the refractive index of the edge-emitting semiconductor structure (21).

12. Semiconductor laser device according to one of Claims 8 to 11,
**characterized in that**
the edge-emitting semiconductor structure (21) is surrounded by air, another gaseous medium or a dielectric.

13. Semiconductor laser device according to one of Claims 8 to 12,
**characterized in that**
the edge-emitting semiconductor structure (21) is formed as a cylindrical body with a circular or annular cross section.

14. Semiconductor laser device according to one of Claims 8 to 12,
**characterized in that**
the edge-emitting semiconductor structure (21) is formed as a prismatic body with a cross section in the form of a polygon or a polygonal ring.

15. Semiconductor laser device according to one of Claims 1 to 14,
**characterized in that**
the edge-emitting semiconductor structure (21) has at least one active layer (25) embedded between a first (23) and a second waveguide layer (24), which are in turn embedded between a first (28) and a second cladding layer (29).

16. Semiconductor laser device according to Claim 15,
**characterized in that**
the interface between edge-emitting semiconductor structure (21) and quantum well structure (11) is at least partly reflective.

17. Semiconductor laser device according to one of Claims 1 to 16,
**characterized in that**
the edge-emitting semiconductor structure (21) has a plurality of active layers (25) which are connected in series by means of tunnel junctions.

18. Semiconductor laser device according to Claims 1 to 17,
**characterized in that**
the radiation-emitting quantum well structure (11) and the pump radiation source (20) are arranged one above the other on the substrate (1), and **in that** the quantum well structure (11) is optically coupled to the edge-emitting semiconductor structure (21), so that pump radiation (2) is guided into the quantum well structure (11) during operation of the semiconductor laser device.

19. Semiconductor laser device according to Claims 1 to 18,
**characterized in that**
the edge-emitting semiconductor structure (21) has a first waveguide layer (23) and a second waveguide layer (24) arranged downstream thereof, as seen from the substrate (1), an active layer (25) being arranged between said waveguide layers, and
**in that** the quantum well structure (11) is grown epitaxially on the second waveguide layer (24), covers only a partial region of the edge-emitting semiconductor structure (21) and is optically coupled to the latter, so that at least a portion of the pump radiation (2) generated in the edge-emitting semiconductor structure (21) is guided into the quantum well structure (11).

20. Semiconductor laser device according to Claims 1 to 19,
**characterized in that**
at least one gain-guided radiation-emitting active region that serves as pump radiation source (20) is formed in the edge-emitting semiconductor structure (21) by means of at least one correspondingly patterned current injection path (26) on the surface of the second waveguide layer (24).

21. Semiconductor laser device according to Claim 19,
**characterized in that**
at least one index-guided radiation-emitting active region that serves as pump radiation source (20) is formed in the edge-emitting semiconductor structure (21) by means of at least one correspondingly patterned current injection path (26) on the surface of the second waveguide layer (24) in conjunction with correspondingly etched trenches in the second waveguide layer (24).

22. Semiconductor laser device according to one of Claims 19 to 21,
**characterized in that**
the refractive index of the second waveguide layer (24) is greater than the refractive index of the first waveguide layer (23).

23. Semiconductor laser device according to one of Claims 19 to 22,
**characterized in that**
the active layer (25) is positioned asymmetrically in the waveguide formed by the two waveguide layers (23, 24) .

24. Semiconductor laser device according to one of Claims 1 to 23,
**characterized in that**
the substrate (1) comprises a material that is transmissive to the laser beam (5) generated in the semiconductor laser device, and **in that**
a resonator mirror layer (3), in particular a Bragg reflector with a highest possible reflection coefficient, is applied over that side of the quantum well structure (11) which is remote from the substrate (1).

25. Method for producing an optically pumped surface-emitting semiconductor laser device, which method has the following method steps:
a) application of an edge-emitting semiconductor layer sequence (21) over a substrate (1);
b) application of a surface-emitting semiconductor laser layer sequence (14) with at least one quantum well structure (11) over the edge-emitting semiconductor layer sequence (21);
c) removal of the surface-emitting semiconductor laser layer sequence (14) outside the envisaged laser region (15), and
d) formation of at least one current injection path (26) in the edge-emitting semiconductor layer sequence (21).

26. Method according to Claim 25,
in which steps a) to c) have the following individual steps:
aa) application of a buffer layer (6) over the substrate (1);
ab) application of a first waveguide layer (23), of an active layer (25) and of a second waveguide layer (24) one after the other over the buffer layer (6),
ba) application of a first confinement layer (12) over the second waveguide layer (24);
bb) application of a quantum well structure (11) suitable for a surface-emitting semiconductor laser over the first confinement layer (12);
bc) application of a second confinement layer (13) over the quantum well structure (11);
ca) removal of the confinement layers (12, 13) and of the quantum well structure (11) and partly of the second waveguide layer (24) outside the envisaged surface-emitting laser region (15).

## Revendications

1. Dispositif laser à semi-conducteur à émission par la surface à pompage optique, comprenant au moins une structure de puits quantique (11) produisant un rayonnement et au moins une source de rayonnement de pompage (20) pour le pompage optique de la structure de puits quantique (11), dans lequel la source de rayonnement de pompage (20) comprend une structure semi-conductrice (21) à émission par le bord, **caractérisé en ce que** la structure de puits quantique (11) produisant un rayonnement et la structure semi-conductrice (21) à émission par le bord comportent chacune une séquence de couches semi-conductrices, que l'on a fait croître successivement par voie épitaxiale sur un substrat commun (1), et qui sont disposées les unes sur les autres.

2. Dispositif laser à semi-conducteur selon la revendication 1, **caractérisé en ce que** la structure de puits quantique (11) est entourée par la structure semi-conductrice (21) à émission par le bord, dans lequel, à l'aide d'au moins un chemin d'injection de courant (16), au moins un domaine actif, émettant un rayonnement, à commande de gain, et qui sert de source de rayonnement de pompage (20), est formé sur une surface de la structure laser à semi-conducteur (21).

3. Dispositif laser à semi-conducteur selon la revendication 1, **caractérisé en ce que** la structure de puits quantique (11) est entourée par la structure semi-conductrice (21) à émission par le bord, dans lequel, à l'aide d'au moins un chemin d'injection de courant (26), au moins un domaine actif, émettant un rayonnement et à commande d'indice, qui sert de source de rayonnement de pompage (20), est défini sur une surface de la structure semi-conductrice en liaison avec des tranchées, formées le long du chemin d'injection de courant (26), dans la structure semi-conductrice (21).

4. Dispositif laser à semi-conducteur selon la revendication 2 ou 3, **caractérisé en ce que** les extrémités des chemins d'injection de courant (26), dirigées vers la structure de puits quantique (11) produisant un rayonnement, se trouvent à une distance de cette dernière de 10 à 50 µm.

5. Dispositif laser à semi-conducteur selon l'une des revendications 1 à 4, **caractérisé en ce que** deux sources de rayonnement de pompage (20) sont disposées sur des côtés opposés l'un à l'autre de la structure de puits quantique (11), et, en fonctionnement, envoient un rayonnement de pompage (2) dans la structure de puits quantique (11).

6. Dispositif laser à semi-conducteur selon l'une des revendications 1 à 5, **caractérisé en ce qu'**un grand nombre de sources de rayonnement de pompage (20) sont disposées en étoile autour de la structure de puits quantique (11), et, en fonctionnement, envoient un rayonnement de pompage (2) dans la structure de puits quantique (11).

7. Dispositif laser à semi-conducteur selon la revendication 5 ou 6, **caractérisé en ce que** deux sources de rayonnement de pompage (20) respectivement, disposées sur des côtés opposés l'un à l'autre de la structure de puits quantique (11), forment ensemble une structure laser pour pompage optique à l'aide d'un rayonnement laser.

8. Dispositif laser à semi-conducteur selon l'une des revendications 1 à 7, **caractérisé en ce que** la source de rayonnement de pompage (20) comprend au moins un laser annulaire.

9. Dispositif laser à semi-conducteur selon la revendication 8, **caractérisé en ce que** la structure de puits quantique (11) est disposée à l'intérieur du résonateur du laser annulaire.

10. Dispositif laser à semi-conducteur selon la revendication 8 ou 9, **caractérisé en ce que** le résonateur du laser annulaire est formé d'un guide d'onde annulaire fermé.

11. Dispositif laser à semi-conducteur selon l'une des revendications 8 à 10, **caractérisé en ce que** la structure semi-conductrice (21) à émission par le bord est entourée d'un milieu dont l'indice de réfraction est inférieur à l'indice de réfraction de la structure semi-conductrice (21) à émission par le bord.

12. Dispositif laser à semi-conducteur selon l'une des revendications 8 à 11, **caractérisé en ce que** la structure semi-conductrice (21) à émission par le bord est entourée par de l'air, par un autre milieu gazeux, ou par un diélectrique.

13. Dispositif laser à semi-conducteur selon l'une des revendications 8 à 12, **caractérisé en ce que** la structure semi-conductrice (21) à émission par le bord est formée de la forme d'un corps cylindrique, ayant une section transversale circulaire ou en forme d'anneau circulaire.

14. Dispositif laser à semi-conducteur selon l'une des revendications 8 à 12, **caractérisé en ce que** la structure semi-conductrice (21) à émission par le bord est formée de la forme d'un corps prismatique, dont la section transversale a la forme d'un polygone ou d'un anneau polygonal.

15. Dispositif laser à semi-conducteur selon l'une des revendications 1 à 14, **caractérisé en ce que** la structure semi-conductrice (21) à émission par le bord comprend au moins une couche active (25), intercalée entre une première (23) et une deuxième (24) couches guides d'ondes (24), lesquelles couches sont intercalées à nouveau entre une première (28) et une deuxième (29) couches formant gaine.

16. Dispositif laser à semi-conducteur selon la revendication 15, **caractérisé en ce que** l'interface entre la structure semi-conductrice (21) à émission par le bord et la structure de puits quantique (11) est au moins partiellement réfléchissante.

17. Dispositif laser à semi-conducteur selon l'une des revendications 1 à 16, **caractérisé en ce que** la structure semi-conductrice (21) à émission par le bord comprend plusieurs couches actives (25), qui sont montées en série à l'aide de jonctions tunnels.

18. Dispositif laser à semi-conducteur selon les revendications 1 à 17, **caractérisé en ce que** la structure de puits quantique (11) émettant un rayonnement et la source de rayonnement de pompage (20) sont disposées l'une sur l'autre sur le substrat (1), et que la structure de puits quantique (11) est optiquement couplée à la structure semi-conductrice (21) à émission par le bord, de telle sorte que, en cours de fonctionnement du dispositif laser à semi-conducteur, le rayonnement de pompage (2) soit envoyé dans la structure de puits quantique (11).

19. Dispositif laser à semi-conducteur selon les revendications 1 à 18, **caractérisé en ce que** la structure semi-conductrice (21) à émission par le bord comprend une première couche guide d'onde (23) et une deuxième couche guide d'onde (24) disposée derrière la première quand on regarde à partir du substrat, entre lesquelles est disposée une couche active (25) ; et que la structure de puits quantique (11) a subi une croissance épitaxiale sur la deuxième couche guide d'onde (24), recouvre seulement un domaine partiel de la structure semi-conductrice (21) à émission par le bord et est optiquement couplée à cette dernière, de telle sorte qu'au moins une partie du rayonnement de pompage (2) produit dans la structure semi-conductrice (21) à émission par le bord soit envoyée dans la structure de puits quantique (11).

20. Dispositif laser à semi-conducteur selon la revendication 19, **caractérisé en ce que**, dans la structure semi-conductrice (21) à émission par le bord, au moins un domaine actif, émettant un rayonnement et à commande de gain, qui sert de source de rayonnement de pompage (20), est formé sur la surface de la deuxième couche guide d'onde (24) à l'aide d'au moins un chemin d'injection de courant (26) structuré d'une manière adéquate.

21. Dispositif laser à semi-conducteur selon la revendication 19, **caractérisé en ce que**, dans la structure semi-conductrice (21) à émission par le bord, au moins un domaine actif émettant un rayonnement, à commande d'indice, et qui sert de source de rayonnement de pompage (20), est formée sur la surface de la deuxième couche guide d'onde (24), en liaison avec des tranchées gravées d'une manière appropriée dans la deuxième couche guide d'onde (24), à l'aide d'au moins un chemin d'injection de courant (26) convenablement structuré.

22. Dispositif laser à semi-conducteur selon l'une des revendications 19 à 21, **caractérisé en ce que** l'indice de réfraction de la deuxième couche guide d'onde (24) est supérieur à l'indice de réfraction de la première couche guide d'onde (23).

23. Dispositif laser à semi-conducteur selon l'une des revendications 19 à 22, **caractérisé en ce que** la couche active (25) est disposée d'une manière dissymétrique dans le guide d'onde formé par les deux couches guides d'ondes (23, 24).

24. Dispositif laser à semi-conducteur selon l'une des revendications 1 à 23, **caractérisé en ce que** le substrat (1) est constitué d'un matériau qui est transparent pour le rayon laser (25) produit dans le dispositif laser à semi-conducteur ; et qu'une couche (3) formant miroir de résonateur, en particulier un réflecteur de Bragg ayant un coefficient de réflexion aussi grand que possible, est disposée sur la face, détachée du substrat (1), de la structure de puits quantique (11).

25. Procédé de fabrication d'un dispositif laser à semi-conducteur à émission par la surface, à pompage optique, qui comprend les étapes suivantes :
a) dépôt, sur un substrat (1), d'une suite (21) de couches semi-conductrices à émission par le bord ;
b) dépôt, sur la suite de couches semi-conductrices (21) à émission par le bord, d'une suite (14) de couches laser à semi-conducteur à émission par la surface, ayant au moins une structure de puits quantique (11) ;
c) enlèvement de la suite (14) de couches laser à semi-conducteur à émission par la surface à l'extérieur du domaine laser prévu (15) ; et
d) formation d'au moins un chemin d'injection de courant (26) dans la suite (21) de couches semi-conductrices à émission par le bord.

26. Procédé selon la revendication 25, dans lequel les étapes a) à c) comprennent les étapes individuelles suivantes :
aa) dépôt d'une couche tampon (6) sur le substrat (1) ;
ab) dépôt, sur la couche tampon (6), successivement d'une première couche guide d'onde (23), d'une couche active (25) et d'une deuxième couche guide d'onde (24),
ba) dépôt, sur la deuxième couche guide d'onde (24), d'une première couche de confinement (12) ;
bb) dépôt, sur la première couche de confinement (12), d'une structure de puits quantique (11) convenant à un laser à semi-conducteur à émission par la surface ;
bc) dépôt, sur la structure de puits quantique (11), d'une deuxième couche de confinement (13) ;
ca) enlèvement des couches de confinement (12, 13) et de la structure de puits quantique (11), et partiellement de la deuxième couche guide d'onde (24), à l'extérieur du domaine laser prévu, à émission par la surface (15).
